# EUROPEAN PATENT APPLICATION

(11) **EP 4 709 117 A1**
(43) Date of publication of application: **11.03.2026**
(21) Application number: 25200208.4
(22) Date of filing: 04.09.2025
(51) Int. Cl.: H10K 59/65, H10K 59/80, H10K 77/10

(54) **METHOD OF MANUFACTURING DISPLAY PANEL, DISPLAY PANEL MANUFACTURED BY USING THE METHOD, AND ELECTRONIC APPARATUS INCLUDING THE DISPLAY PANEL**

(30) Priority: 06.09.2024 KR 20240121801; 26.11.2024 KR 20240171449
(71) Applicant: Samsung Display Co., Ltd., Yongin-si, Gyeonggi-do 17113 (KR)
(72) Inventor: Kim, Daeil, 17113 Yongin-si, Gyeonggi-do (KR); KIM, Jeehoon, 17113 Yongin-si, Gyeonggi-do (KR); Lee, Yunkyu, 17113 Yongin-si, Gyeonggi-do (KR); Cha, Soonkyu, 17113 Yongin-si, Gyeonggi-do (KR); Kim, Jinyool, 17113 Yongin-si, Gyeonggi-do (KR); Kim, Sunhwa, 17113 Yongin-si, Gyeonggi-do (KR); Han, Dongwon, 17113 Yongin-si, Gyeonggi-do (KR)
(74) Representative: Gulde & Partner

(57) **Abstract**

A method of manufacturing a display panel (10), a display panel (10) manufactured by using the method, and an electronic apparatus (1) including the display panel (10) are provided. The method includes forming a display layer (DIL) on a first surface of a substrate (100) having the first surface and a second surface which face away from each other, etching the second surface of the substrate (100) to reduce the thickness of the substrate (100) and removing a portion of the substrate (100) corresponding to a hole-forming area to form a first hole (H1) in the substrate (100), forming a polarization layer (POL) to correspond to an entire surface of the display layer (DIL) to be located such that the display layer (DIL) is interposed between the polarization layer (POL) and the substrate (100), and forming a second hole (H2) coupled to the first hole (H1) by removing a portion of the polarization layer (POL) and a portion of the display layer (DIL) which correspond to an edge of the hole-forming area.

## Description

### CROSS-REFERENCE TO RELATED APPLICATION

This application claims priority to and the benefit of Korean Patent Application No. 10-2024-0121801, filed on September 6, 2024, and Korean Patent Application No. 10-2024-0171449, filed on November 26, 2024, in the Korean Intellectual Property Office, the entire disclosures of each of which are incorporated herein by reference.

### BACKGROUND

### 1. Field

One or more aspects of embodiments of the present disclosure relate to a method of manufacturing a display panel, a display panel manufactured by using the method, and an electronic apparatus including the display panel. For example, embodiments of the present disclosure relate to a method of manufacturing a display panel having a low defect rate, a display panel manufactured by using the method, and an electronic apparatus including the display panel.

### 2. Description of the Related Art

A display panel of an electronic apparatus such as a television, a monitor, a smartphone, a tablet PC, and/or the like includes a display area and a peripheral area outside the display area. In electronic apparatuses including such display panels, a larger relative area of the display area is desired or required, and one or more suitable functions are being added to the electronic apparatuses. Accordingly, research is being conducted on display panels capable of including or providing one or more suitable components in the display area and electronic apparatuses including the display panels.

### SUMMARY

Comparable display panels and electronic apparatuses including the comparable display panels have a problem in that a defect frequently occurs during the manufacturing process or while the display panels or the electronic apparatuses are in use.

One or more aspects of embodiments of the present disclosure are directed toward a method of manufacturing a display panel having a low defect occurrence rate, a display panel manufactured by using the method, and an electronic apparatus including the display panel.

However, it should be noted that these objectives are merely examples, and the scope of the disclosure is not limited to the herein-mentioned aspects. Rather, other objectives of one or more embodiments of the present disclosure will be apparent to those skilled in the art from the following descriptions.

Additional aspects of one or more embodiments will be set forth in part in the description which follows and, in part, will be apparent from the description, or may be learned by practice of the presented embodiments of the disclosure.

The present invention is set out in the appended set of claims. According to one or more embodiments, a method of manufacturing a display panel includes providing a display layer on a first surface of a substrate having the first surface and a second surface which are opposite (face away) from each other, etching the second surface of the substrate to reduce the thickness of the substrate and removing a portion of the substrate corresponding to a hole-forming area to form a first hole in the substrate, providing a polarization layer to correspond to an entire surface of the display layer to be located such that the display layer is interposed between the polarization layer and the substrate, and providing a second hole coupled to the first hole by removing a portion of the polarization layer and a portion of the display layer, each of the portion of the polarization layer and the portion of the display layer which correspond to an edge of the hole-forming area. For example, an organic film, e.g. an organic insulating layer, may be disposed on the first surface of the substrate and between the display layer. For example, the organic film on the first surface of the substrate may be removed, e.g. due to a laser irradiation, such that no organic layer exists between the substrate and the display layer in a section corresponding to the first hole. Organic layers may cause penetration of moisture into the display layer, thereby causing defects, for example, of organic light-emitting diodes in the display area. Since the manufactured display panel does not include an organic film on the first surface of the substrate between the display layer and the first hole, the occurrence of defects, e.g. caused by moisture penetrating through the organic layer, may be reduced.

The method may further include providing a scratch in the substrate to correspond to the edge of the hole-forming area, wherein the etching of the second surface of the substrate includes etching the second surface of the substrate so that an etchant penetrates the scratch and thus the portion of the substrate corresponding to the hole-forming area is removed.

The providing of the second hole may include irradiating a laser beam to the portion of the polarization layer corresponding to the edge of the hole-forming area.

The providing of the second hole may include irradiating the laser beam to the portion of the polarization layer until a portion (part) of the first surface of the substrate corresponding to the edge of the hole-forming area is exposed.

The method may further include providing a bottom protective layer covering a lower surface of the display layer exposed by the first hole, the second surface of the substrate, and an inner side surface of the first hole.

The providing of the second hole may include irradiating the laser beam so that a portion of the bottom protective layer on the inner side surface of the first hole is removed.

The providing of the second hole may include irradiating the laser beam so that a portion of the bottom protective layer on the second surface of the substrate is removed to expose a portion of the second surface of the substrate surrounding the first hole. For example, the substrate may be transparent to allow the laser beam to transmit through the substrate and to the bottom protective layer on the second surface of the substrate.

According to one or more embodiments, a display panel includes a substrate having a first surface and a second surface opposite to the first surface (e.g., the first and second surfaces may face away from each other) and having a first hole passing through the first surface and the second surface, and a display layer and a polarization layer on the display layer which is over and/or directly on the first surface of the substrate and has a second hole, the second hole overlapping the first hole when viewed from a direction perpendicular to the substrate, wherein an inner side surface of the second hole is a continuous surface excluding (without) a step up to the first surface of the substrate, and a portion of the first surface between the display layer and the first hole excludes an organic film (e.g., no organic film exists on the first surface of the substrate between the display layer and the first hole). For example, an organic film, e.g. an organic insulating layer, may be disposed on the first surface of the substrate and between the display layer, whereas the organic film is left out on the first surface of the substrate between the display layer and the first hole. For example, the organic film on the first surface of the substrate may be removed, e.g. due to a laser irradiation, such that no organic layer exists between the substrate and the display layer in a section corresponding to the first hole. Organic layers may cause penetration of moisture into the display layer, thereby causing defects, for example, of organic light-emitting diodes in the display area. Since the display panel does not include an organic film on the first surface of the substrate between the display layer and the first hole, the occurrence of defects, e.g. caused by moisture penetrating through the organic layer, may be reduced.

An area of the second hole at a lower surface of the polarization layer in a direction toward (to) the display layer may be equal to an area of the second hole at an upper surface of the display layer in a direction toward (to) the polarization layer.

The second hole may be configured to expose a portion of the first surface of the substrate.

A portion of the first surface of the substrate exposed by the second hole may be around (surround) the first hole.

The display panel may further include a bottom protective layer on the second surface of the substrate and having a third hole corresponding to the first hole.

An area of the third hole may be greater than an area of the first hole.

An area of the third hole at an upper surface of the bottom protective layer in a direction toward (to) the substrate may be equal to an area of the second hole at a lower surface of the display layer in the direction toward (to) the substrate.

When viewed from the direction perpendicular to the substrate, an edge of the third hole may overlap an edge of the second hole at a lower surface of the display layer in a direction toward (to) the substrate.

An edge of the third hole of the bottom protective layer may include a thermally deformed portion.

An edge of the second hole of the polarization layer may include a thermally deformed portion.

According to one or more embodiments, an electronic apparatus includes a display panel, a camera, and a lower cover, wherein the display panel includes a substrate having a first surface and a second surface opposite to the first surface (e.g., the first and second surfaces face away from each other) and having a first hole passing through the first surface and the second surface, and a display layer and a polarization layer on the display layer which is over the first surface of the substrate and have a second hole, the second hole overlapping the first hole when viewed from a direction perpendicular to the substrate, wherein an inner side surface of the second hole is a continuous surface excludes (without) a step up to the first surface of the substrate, a portion of the first surface between the display layer and the first hole excludes an organic film (e.g., no organic film exists on the first surface of the substrate between the display layer and the first hole), and the camera is between the display panel and the lower cover. In other words, the electronic apparatus includes the above-mentioned display panel.

An area of the second hole at a lower surface of the polarization layer in a direction toward (to) the substrate may be equal to an area of the second hole at an upper surface of the display layer in a direction toward (to) the polarization layer.

The second hole may be configured to expose a portion of the first surface of the substrate.

A portion of the first surface of the substrate exposed by the second hole may be around (surround) the first hole.

The electronic apparatus may further include a bottom protective layer on the second surface of the substrate and having a third hole corresponding to the first hole.

An area of the third hole may be greater than an area of the first hole.

An area of the third hole is equal to an area of the second hole at a lower surface of the display layer in a direction to the substrate.

When viewed from the direction perpendicular to the substrate, an edge of the third hole may overlap an edge of the second hole at a lower surface of the display layer in a direction toward (to) the substrate.

An edge of the third hole of the bottom protective layer may include a thermally deformed portion.

An edge of the second hole of the polarization layer includes a thermally deformed portion.

Other aspects and features beyond those described herein will become apparent from the following drawings, claims, and detailed description of the disclosure.

### BRIEF DESCRIPTION OF THE DRAWINGS

The accompanying drawings are included to provide a further understanding of the preceding and other aspects and features advantages of certain embodiments of the disclosure and are incorporated in and constitute a part of this specification. The drawings illustrate example embodiments that will be more apparent from the following description taken in conjunction with the accompanying drawings. In the drawings:
FIG. 1 is a perspective view schematically illustrating an electronic apparatus according to one or more embodiments;
FIG. 2 is an exploded perspective view schematically illustrating the electronic apparatus of FIG. 1;
FIG. 3 is a block diagram schematically illustrating the electronic apparatus of FIG. 1;
FIG. 4 is a plan view schematically illustrating a display panel according to one or more embodiments;
FIG. 5 is a side view schematically illustrating the display panel of FIG. 4;
FIG. 6 is a cross-sectional view schematically illustrating a cross-section of the display panel taken along line A-A' of FIG. 4;
FIGS. 7-14 are cross-sectional views schematically illustrating manufacturing steps for manufacturing the display panel of FIG. 6;
FIG. 15 is a plan view schematically illustrating a display panel included in the electronic apparatus of FIG. 1;
FIG. 16 is an equivalent circuit diagram of a pixel circuit electrically coupled to a light-emitting diode included in the display panel of FIG. 15;
FIG. 17 is a plan view schematically illustrating a portion of the display panel of FIG. 15;
FIG. 18 is a cross-sectional view schematically illustrating a cross-section of the display panel taken along line B-B' of FIG. 17; and
FIG. 19 is a cross-sectional view schematically illustrating a portion of a display panel according to one or more embodiments.

### DETAILED DESCRIPTION

Reference will now be made in more detail to embodiments, examples of which are illustrated in the accompanying drawings, wherein like reference numerals refer to like elements throughout. In this regard, the present embodiments may have different forms and should not be construed as being limited to the descriptions set forth herein. Rather, these embodiments are provided so that this disclosure will be thorough and complete, and will fully convey the scope of the present disclosure to those skilled in the art. Accordingly, the embodiments are merely described herein, by referring to the figures, to explain aspects of embodiments of the present description.

As used herein, the term "and/or" includes any and all combinations of one or more of the associated listed items. Throughout the disclosure, the expression "at least one of a, b or c" indicates only a, only b, only c, both (e.g., simultaneously) a and b, both (e.g., simultaneously) a and c, both (e.g., simultaneously) b and c, all of a, b, and c, or variations thereof.

As the disclosure allows for one or more suitable changes and numerous embodiments, example embodiments will be illustrated in the drawings and described in more detail in the written description. Effects and features of the disclosure and methods of achieving the same will be apparent with reference to embodiments and drawings described herein in detail. The subject matter of the disclosure may, however, be embodied in many different forms and should not be construed as being limited to the embodiments set forth herein.

Hereinafter, embodiments of the disclosure will be described in more detail with reference to the accompanying drawings, and in the description with reference to the drawings, the same or corresponding components are indicated by the same reference numerals and redundant descriptions thereof may not be repeated.

In the following embodiments, when an element, such as a layer, a film, a region, or a plate, is referred to as being "on" another element, the element can be directly on the other element, or intervening elements may be present therebetween. Also, sizes of elements in the drawings may be exaggerated or reduced for convenience of descriptions. For example, because sizes and thicknesses of elements in the drawings may be arbitrarily illustrated for convenience of descriptions, the following embodiments are not limited thereto.

In the following embodiments, the x-axis, the y-axis, and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

In the following embodiments, while terms such as "first" and "second" are used to describe one or more suitable elements, these elements are not limited by these terms. These terms are only used to distinguish one element from another element.

In the following embodiments, terms such as "include," "includes," "including," "comprise," "comprises," "comprising," "has," "having," and "have" specify the presence of stated features or elements, but do not preclude the presence or addition of one or more other features or elements. Singular expressions such as "a," "an," and "the," include plural expressions unless clearly otherwise indicated in the context.

In the present specification, the expression "A and/or B" represents A, B, or A and B. Also, the expression "at least one of A and B" represents A, B, or A and B.

In the following embodiments, when a layer, region, or element is referred to as being "coupled to" or "connected to" another layer, region, or element, it can be directly or indirectly coupled or connected to the other layer, region, or element. For example, intervening layers, regions, or elements may be present. For example, when a layer, region, or element is referred to as being "electrically connected to" or "electrically coupled to" another layer, region, or element, it can be directly or indirectly electrically connected or coupled to the other layer, region, or element. For example, intervening layers, regions, or elements may be present.

Spatially relative terms, such as "beneath," "below," "lower," "above," "upper," "bottom," "top," and/or the like, may be used herein for ease of description to describe one element or feature's relationship to another element(s) or feature(s) as illustrated in the drawings. It will be understood that the spatially relative terms are intended to encompass different orientations of the device in use or operation in addition to the orientation depicted in the drawings. For example, if the device in the drawings is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

Unless otherwise defined, all terms (including chemical, technical terms and scientific terms) used in the present specification have the same meaning as commonly understood by those skilled in the art to which the present disclosure belongs. Furthermore, terms such as terms defined in the dictionaries commonly used should be interpreted as having a meaning consistent with the meaning in the context of the related technology and should not be interpreted in overly ideal or overly formal meanings unless explicitly defined herein.

The term "may" will be understood to refer to "one or more embodiments of the present disclosure," some of which include the described element and some of which exclude that element and/or include an alternate element. Similarly, alternative language such as "or" refers to "one or more embodiments of the present disclosure," each including a corresponding listed item.

As used herein, the phrase "consisting essentially of" indicates that any additional components will not materially affect the chemical, physical, optical or electrical properties of the semiconductor film.

Hereinafter, a display panel and an electronic apparatus according to one or more embodiments of the present disclosure will be described with reference to the accompanying drawings.

### Electronic apparatus

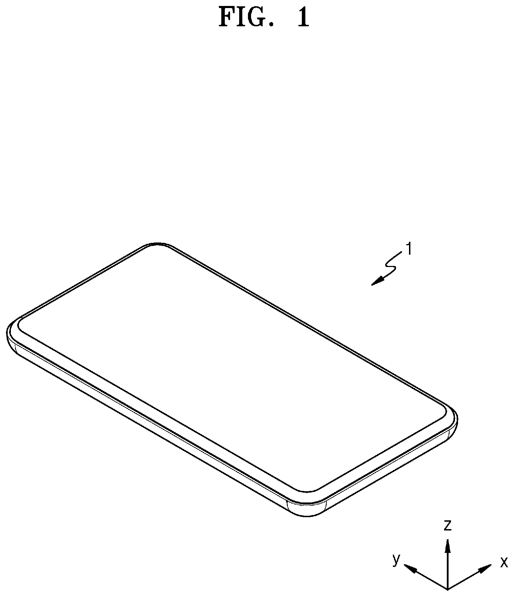

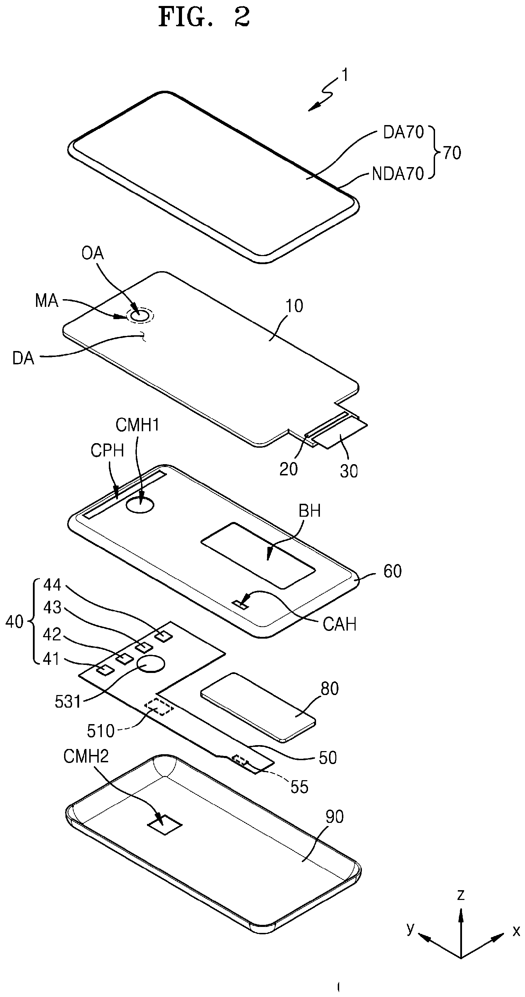

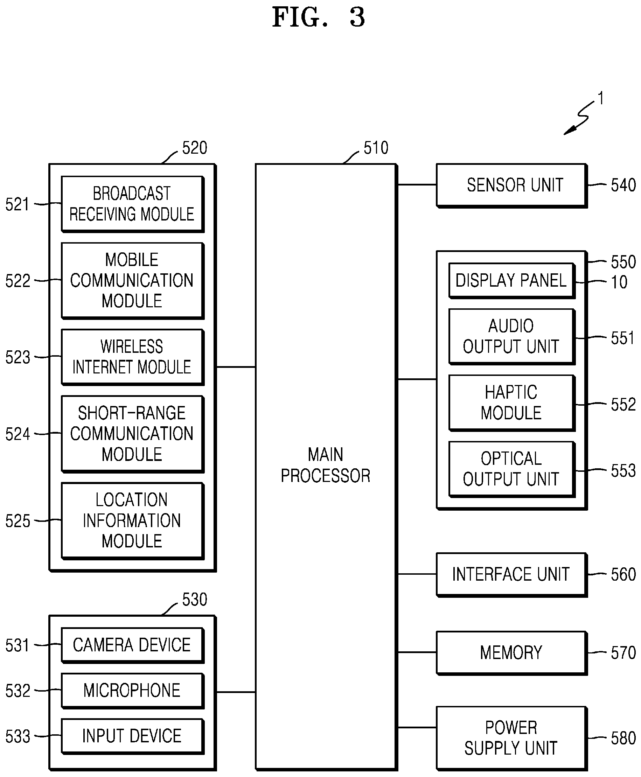

FIG. 1 is a perspective view schematically illustrating an electronic apparatus 1 according to one or more embodiments, FIG. 2 is an exploded perspective view schematically illustrating the electronic apparatus 1 of FIG. 1, and FIG. 3 is a block diagram schematically illustrating the electronic apparatus 1 of FIG. 1.

Referring to FIGS. 1 and 2, the electronic apparatus 1, which is a device for displaying moving images and/or still images, may be used for a portable electronic apparatus, such as a mobile phone, a smartphone, a tablet personal computer (PC), a mobile communication terminal, an electronic notebook, an electronic book, a portable multimedia player (PMP), a navigation, and/or an ultra-mobile PC (UMPC), and/or may be a variety of suitable products, such as televisions, laptops, monitors, billboards, and/or Internet of things (IoT) devices. The electronic apparatus 1 according to one or more embodiments may also be a wearable device such as a smart watch, a watch phone, a glasses-type (kind) display, and/or a head-mounted display (HMD). The electronic apparatus 1 according to one or more embodiments may also be an instrument panel of a vehicle, a center fascia of a vehicle and/or a center information display (CID) on a dashboard, a room mirror display replacing a side view mirror of a vehicle, and/or a display on the rear side of a front seat as an entertainment device for a passenger in the backseat of a vehicle.

In FIGS. 1 and 2, for convenience of descriptions, the electronic apparatus 1 according to one or more embodiments is illustrated as a smartphone. However, the present disclosure is not limited thereto. The electronic apparatus 1 may include a cover window 70, a display panel 10, a data driver 20, a display circuit board 30, a component 40, a bracket 60, a main circuit board 50, a battery 80, and/or a lower cover 90.

In the plan view of this specification, "left," "right," "up," and "down" indicate directions when the display panel 10 is viewed from a direction perpendicular to the display panel 10. For example, "left" indicates a -x direction, "right" indicates a +x direction, "up" indicates a +y direction, and "down" indicates a -y direction.

The electronic apparatus 1 may appear to have an approximately rectangular shape in a plan view. For example, as shown in FIG. 1, the electronic apparatus 1 may have an approximately rectangular shape having a short side in the x-axis direction and a long side in the y-axis direction in the xy-plane. A corner at which the short side in the x-axis direction meets the long side in the y-axis direction may be rounded to have a set or certain curvature or provided (e.g., formed) at a right angle. The planar shape of the electronic apparatus 1 is not limited to a rectangle, and may include other polygonal, elliptical, or irregular shapes.

The cover window 70 may be over the display panel 10 to cover an upper surface of the display panel 10. The cover window 70 may protect the upper surface of the display panel 10.

The cover window 70 may include a transparent cover unit DA70 corresponding to the display panel 10 and a light-shielding cover unit NDA70 surrounding the transparent cover unit DA70. Light from the display area DA of the display panel 10 may pass through the transparent cover unit DA70 and proceed to the outside. The light-shielding cover unit NDA70 may include an opaque material (e.g., a colored opaque material) that blocks light (or reduces transmission of light). The light-shielding cover unit NDA70 may include a pattern that is visible to the user when no image is displayed.

The cover windows 70 may include glass and/or plastic. If the cover window 70 includes glass, the cover window 70 may include ultra-thin glass. If the cover window 70 includes plastic, the cover window 70 may include polyethersulfone, polyacrylate, polyether imide, polyethylene naphthalate, polyethylene terephthalate, polyphenylene sulfide, polyarylate, polyimide, polycarbonate, and/or cellulose acetate propionate.

The display panel 10 may be below the cover window 70. The display panel 10 may overlap the transparent cover unit DA70 of the cover window 70. The display panel 10 may include a display area DA. The display area DA is an area where an image may be displayed. The display area DA may include an area (hereinafter, component area) that transmits light emitted from a component 40 or a camera 531 below the display panel 10 or transmits light proceeding toward the component 40 or the camera 531. In embodiments, the display area DA may be referred to as being outside the component area to surround the component area. The component 40 may include a sensor that uses visible light, infrared light, sound, and/or the like.

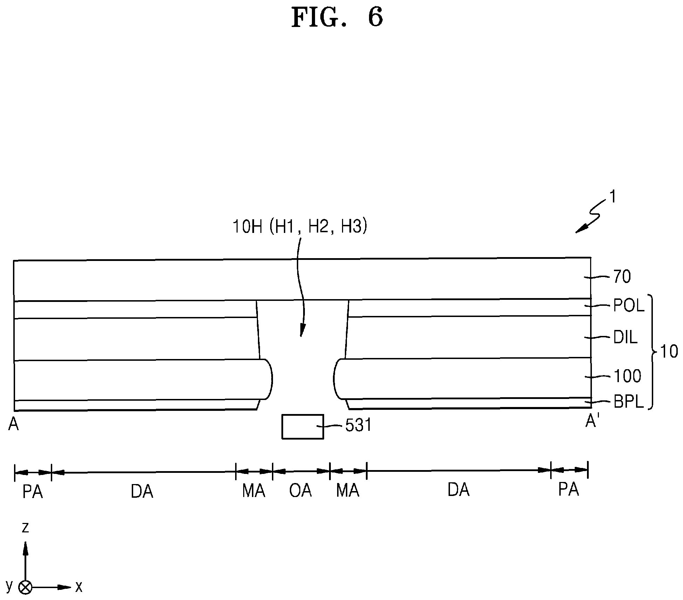

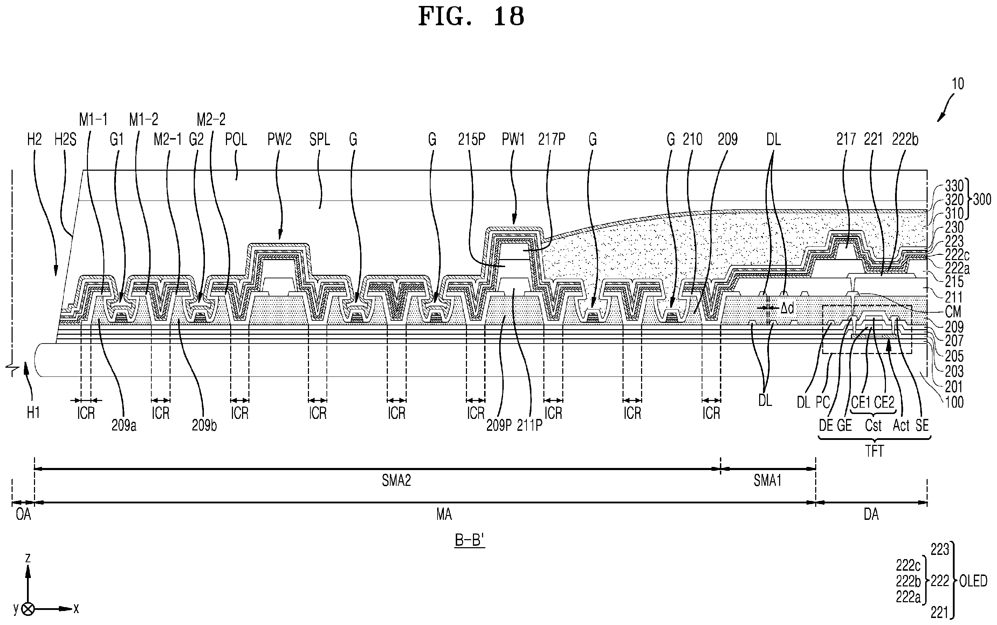

An opening area OA may be located within the display area DA. The opening area OA may be (e.g., defined by) an opening of a substrate 100 (see FIGS. 6 and 18) included in the display panel 10. The opening area OA may be (e.g., located) in the upper center of the display area DA as shown in FIG. 2, and the display area DA outside the opening area OA may have a shape that surrounds the opening area OA. In one or more embodiments, the opening area OA may be located within the display area DA in one or more suitable ways, such as being (e.g., located) at an upper left portion of the display area DA or at an upper right portion of the display area DA. Although FIG. 2 shows that one opening area OA is located within the display area DA, the display panel 10 may have a plurality of opening areas OA.

The component area described herein may be or include such an opening area OA. FIG. 2 shows that the location of the opening area OA corresponds to the location of the camera 531 below the display panel 10. For example, in the plan view, the opening area OA may overlap the camera 531. In one or more embodiments, the location of the opening area OA may correspond to the location of at least a part of the component 40, if necessary. For example, in the plan view, the opening area OA may overlap at least one of the first component 41, the second component 42, the third component 43, and the fourth component 44 included in the component 40. Hereinbelow, for convenience of descriptions, it is described that the location of the opening area OA corresponds to the location of the camera 531 below the display panel 10.

An intermediate area MA, which may be referred to as a first area, may be located between the display area DA and the opening area OA. For example, the intermediate area MA, which may be referred to as the first area, may be located outside the opening area OA. The intermediate area MA may have a closed loop shape that entirely surrounds the opening area OA in the plan view. The display area DA may be said to be a second area outside the first area.

The display panel 10 may be a light-emitting display panel including a light-emitting diode. The light-emitting diode may be an organic light-emitting diode (OLED) including an organic light-emitting layer (an organic emission layer) and/or an inorganic light-emitting diode including an inorganic material. The inorganic light-emitting diode may include a PN diode including inorganic semiconductor-based materials. When a voltage is applied in a forward direction to a PN junction diode, holes and electrons may be injected, and energy generated by recombination of the holes and electrons may be converted into light energy so that light of a set or certain color is emitted. The inorganic light-emitting diode described herein may have a width of several to several hundred micrometers. The inorganic light-emitting diodes may be referred to as micro light-emitting diodes (LEDs).

The display panel 10 may be a rigid display panel that is rigid and is not easily bendable or a flexible display panel that is easily bendable, foldable, and/or rollable. For example, the display panel 10 may be a foldable display panel, a curved display panel having a curved display surface, a bended display panel in which an area other than a display surface is bent, a rollable display panel that may be rolled and/or unrolled, and/or a stretchable display panel.

The display panel 10 may be a transparent display panel that allows an object or background in a rear side of the display panel 10 to be visible from a front side of the display panel 10. In embodiments, the display panel 10 may be a reflective display panel capable of reflecting light from an object in front of the display panel 10 or light from the background in the rear side of the display panel 10.

The data driver 20 may be mounted on the display panel 10 in the form of an integrated circuit (IC). In another embodiment, the data driver 20 may be on the display circuit board 30.

The display circuit board 30 may be on (e.g., affixed to) one side of the display panel 10. The display circuit board 30 may be a flexible printed circuit board (FPCB) that may be bent, a rigid printed circuit board (PCB) that is hard and is not easily bendable, or a composite printed circuit board including both (e.g., simultaneously) an FPCB and a rigid PCB. A touch sensor driving unit may be mounted on the display circuit board 30. The touch sensor driving unit may be provided (e.g., formed) as an IC. The touch sensor driving unit may be electrically coupled to touch electrodes of a touch screen layer of the display circuit board 30 through the display circuit board 30.

The touch screen layer of the display panel 10 may detect a user's touch input by using at least one of one or more suitable touch methods such as a resistive film method and an electrostatic capacitance method. When the touch screen layer of the display panel 10 detects a user's touch input in an electrostatic capacitive manner, the touch sensor driving unit may apply driving signals to driving electrodes of the touch electrodes and detect, through sensing electrodes of the touch electrodes, voltages charged in mutual electrostatic capacitances (hereinafter, referred to as "mutual capacitance") between the driving electrodes and the sensing electrodes, thereby determining whether a user's touch is received.

The user's touch may include a contact touch and a proximity touch. The contact touch indicates that a user's finger or an object such as a pen is in direct contact with the cover window 70 on the touch screen layer. The proximity touch indicates that a user's finger or an object such as a pen is positioned close to the cover window 70, such as hovering. The touch sensor driving unit may transmit sensor data to a main processor 510 according to the detected voltages, and the main processor 510 may analyze the sensor data and calculate touch coordinates at which a touch input has occurred.

A control unit to supply a driving voltage for driving pixels of the display panel 10, a gate driver, and the data driver 20 may be on the display circuit board 30.

The bracket 60 to support the display panel 10 may be below the display panel 10. The bracket 60 may include plastic, metal, or both plastic and metal. The bracket 60 may have a first camera hole CMH1 into which the camera 531 is inserted, a battery hole BH in which the battery 80 is provided, a cable hole CAH through which a cable coupled to the display circuit board 30 passes, and a component hole CPH corresponding to components 40. The component hole CPH may overlap the components 40 of the main circuit board 50 when viewed from a third direction (z-axis direction). For reference, the display area DA of the display panel 10 may overlap the components 40 of the main circuit board 50 when viewed from the third direction (z-axis direction). In another embodiment, the bracket 60 may not have a component hole CPH.

The components 40 of the electronic apparatus 1 may include a first component 41, a second component 42, a third component 43, and a fourth component 44 which overlap the display panel 10. Each of the first component 41, the second component 42, the third component 43, and the fourth component 44 may include at least one selected from a proximity sensor, an illumination sensor, an iris sensor, a face recognition sensor, and a camera (or image sensor). The proximity sensor using infrared rays may detect an object close to an upper surface of the electronic apparatus 1, and the illumination sensor may detect brightness of light incident on the upper surface of the electronic apparatus 1. In some embodiments, the iris sensor may photograph a person's iris over the upper surface of the electronic apparatus 1, and the camera may photograph an object over the upper surface of the electronic apparatus 1. The components 40 are not limited to a proximity sensor, an illumination sensor, an iris sensor, a face recognition sensor, and a camera, and may include one or more suitable sensors.

The main circuit board 50 and the battery 80 may be below the bracket 60. The main circuit board 50 may be a printed circuit board or a FPCB.

The main circuit board 50 may include the main processor 510, the camera 531, a main connector 55, and the components 40. The main processor 510 may be provided (e.g., formed) as an IC. When necessary or desired, the electronic apparatus 1 may include not only the camera 531 over the upper surface of the main circuit board 50 but also a camera below a lower surface of the main circuit board 50. Each of the main processor 510 and the main connector 55 may be on either one of the upper and lower surfaces of the main circuit board 50. The main circuit board 50 may be electrically coupled to the display circuit board 30 through the main connector 55, and/or the like.

The main processor 510 may control some or all functions of the electronic apparatus 1. For example, the main processor 510 may output digital video data to the data driver 20 so that an image is displayed on the display panel 10. The main processor 510 may receive input of sensing data from the touch sensor driving unit. The main processor 510 may determine whether a user's touch is received according to the sensing data, and execute an operation corresponding to a direct touch and/or proximity touch of the user. The main processor 510 may be an application processor, a central processing unit, and/or a system chip, each of which include an IC.

The camera 531 may process image frames of a still image, a moving image, and/or the like obtained by an image sensor in a camera mode, and output the processed image frames to the main processor 510. The camera 531 may include at least one selected from a camera sensor (e.g., charge-coupled device (CCD), complementary metal-oxide-semiconductor (CMOS), and/or the like), a photo sensor (or image sensor), and/or a laser sensor.

The cable, which passes through the cable hole CAH defined in the bracket 60, may be coupled to the main connector 55, and thus the main connector 55 may be electrically coupled to the display circuit board 30.

The electronic apparatus 1 may be represented by a block diagram as shown in FIG. 3. The electronic apparatus 1 may be represented as including, in addition to the main processor 510, a wireless communication unit 520, an input unit 530, a sensor unit 540, an output unit 550, an interface unit 560, a memory 570, and/or a power supply unit 580 shown in FIG. 3.

The wireless communication unit 520 may include at least one of a broadcast receiving module 521, a mobile communication module 522, a wireless Internet module 523, a short-range communication module 524, or a location information module 525.

The broadcast receiving module 521 may receive broadcast signals and/or broadcast-related information from an external broadcast management server via a broadcast channel. The broadcast channel may include satellite channels and terrestrial channels.

The mobile communication module 522 may transmit and receive wireless signals to and from at least one of an external terminal, a server on a mobile communication network, or a base station established according to technology standards or communication methods for mobile communication (e.g., Global System for Mobile Communication (GSM), Code Division Multi Access (CDMA), Code Division Multi Access 2000 (CDMA2000), Enhanced Voice-Data Optimized or Enhanced Voice-Data Only (EV-DO), Wideband CDMA (WCDMA), High Speed Downlink Packet Access (HSDPA), High Speed Uplink Packet Access (HSUPA), Long Term Evolution (LTE), and Long Term Evolution-Advanced (LTE-A)). The wireless signal may include voice call signals, video call signals, and/or one or more suitable forms of data according to text/multimedia message transmission and reception.

The wireless Internet module 523 is a module for wireless Internet connection. The wireless Internet module 523 may be configured to transmit and receive wireless signals in a communication network according to wireless Internet technologies. The wireless Internet technology may include, for example, Wireless LAN (WLAN), Wireless-Fidelity (Wi-Fi), Wi-Fi Direct, Digital Living Network Alliance (DLNA), and/or the like.

The short-range communication module 524, which ensures short-range communication, may support short-range communication by using at least one of Bluetooth, Radio Frequency Identification (RFID), Infrared Data Association (IrDA), Ultra-Wideband (UWB), ZigBee, Near Field Communication (NFC), Wi-Fi, Wi-Fi Direct, or Wireless Universal Seral Bus (USB) technologies. The short-range communication module 524 may support wireless communication between the electronic apparatus 1 and a wireless communication system, between the electronic apparatus 1 and another electronic apparatus, or the electronic apparatus 1 and a network where another electronic apparatus (or external server) is located, through wireless area networks. The wireless area networks may be wireless personal area networks. The other electronic apparatus may be a wearable device capable of mutually exchanging data with (or linking with) the electronic apparatus 1.

The location information module 525, which is a module that obtains a location (or current location) of the electronic apparatus 1, may include a global positioning system (GPS) module and/or a Wi-Fi module.

The input unit 530 may include an image input unit such as the camera 531 to input an image signal, an audio input unit such as a microphone 532 to input an audio signal, and an input device 533 to receive information from a user. The camera 531 may process image frames, such as still images and/or moving images, obtained by an image sensor in a video call mode and/or shooting mode. The processed image frames may be displayed on the display panel 10 or stored in the memory 570. The microphone 532 may process external audio signals into electrical sound data. The processed sound data may be variously used according to a function being performed (or application being run) in the electronic apparatus 1.

The main processor 510 may control an operation of the electronic apparatus 1 to correspond to information received via the input device 533. The input device 533 may include a mechanical input component, such as a button positioned on the rear surface or side surface of the electronic apparatus 1, a dome switch, a jog wheel, or a jog switch, and/or a touch input component. The touch input component may include a touch screen layer of the display panel 10.

The sensor unit 540 may include one or more sensors configured to sense at least one of information within the electronic apparatus 1, surrounding environment information of the electronic apparatus 1, or user information, and generate a sensing signal corresponding thereto. Based on this sensing signal, the main processor 510 may control driving and/or operation of the electronic apparatus 1 and/or perform data processing, functions, and/or operations associated with applications installed in the electronic apparatus 1. The sensor unit 540 may be a proximity sensor, an illumination sensor, and/or a facial recognition sensor as described herein with respect to the component 40. The sensor unit 540 may include an acceleration sensor, a magnetic sensor, a G-sensor, a gyroscope sensor, a motion sensor, an RGB sensor, an infrared (IR) sensor, a finger scan sensor, an ultrasonic sensor, an optical sensor, and/or a battery gauge. In some embodiments, the sensor unit 540 may include an environmental sensor and/or a chemical sensor. The environmental sensors may include, for example, a barometer, a hygrometer, a thermometer, a radiation detection sensor, a heat detection sensor, and/or a gas detection sensor. Chemical sensors may include, for example, an electronic nose, a healthcare sensor, and/or a biometric recognition sensor.

The output unit 550 may generate an output associated with vision, hearing, and tactile sensations, and may include at least one of the display panel 10, an audio output unit 551, a haptic module 552, or an optical output unit 553.

The display panel 10 may be configured to display (or output) information processed in the electronic apparatus 1. For example, the display panel 10 may be configured to display execution screen information of an application driven in the electronic apparatus 1, and/or to display user interface (UI) and/or graphic user interface (GUI) information according to the execution screen information. The display panel 10 may include a display layer to display images and a touch screen layer to detect a touch input of a user. Therefore, the display panel 10 may function as one of the input devices 533 that provide an input interface between the electronic apparatus 1 and the user, and at the same time, may function as the output units 550 that provide an output interface between the electronic apparatus 1 and the user.

The audio output unit 551 may output audio data received from the wireless communication unit 520 or stored in the memory 570 in a call signal reception mode, a call mode or recording mode, a speech recognition mode, a broadcast reception mode, and/or the like. The audio output unit 551 may output audio signals associated with functions performed in the electronic apparatus 1, such as call signal reception sound, message reception sound, and/or the like. The audio output unit 551 may include a receiver and/or a speaker. At least one of the receiver or the speaker may be a sound generation device that is attached below the display panel 10 and vibrate the display panel 10 to output sound. The sound generation device may be a piezoelectric element, and/or piezoelectric actuator, that contracts and expands in response to an electric signal, and/or an exciter that generates a magnetic force by using a voice coil and vibrates the display panel 10.

The haptic module 552 may generate one or more suitable tactile effects that may be felt by the user. The haptic module 552 may provide vibration to the user as a tactile effect. The haptic module 552 may not only transfer a tactile effect through direct contact, but also may be implemented such that the user may feel the tactile effect through muscle sensations in the fingers and/or arms.

The optical output unit 553 may output a signal to notify the user of the occurrence of an event by using light from a light source. Examples of events occurring in the electronic apparatus 1 may include receiving a message, receiving a call signal, receiving a missed call, an alarm, a schedule alarm, a schedule reminder, receiving an e-mail, receiving information through an application, and the like. The signal output from the optical output unit 553 may be implemented as the electronic apparatus 1 emits light of a single color or a plurality of colors from the front or rear thereof. The outputting of the signal may be terminated when the electronic apparatus 1 detects the user's identification of the event.

The interface unit 560 serves as a passageway for one or more suitable types (kinds) of external devices coupled to the electronic apparatus 1. The interface unit 560 may include at least one of a wired/wireless headset port, an external charger port, a wired/wireless data port, a memory card port, a port connecting a device equipped with an identification module, an audio input/output (I/O) port, a video I/O port, or an earphone port. When the electronic apparatus 1 is coupled to an external device through the interface unit 560, the electronic apparatus 1 may perform an appropriate or suitable control associated with the coupled external device.

The memory 570 may store data supporting one or more suitable functions of the electronic apparatus 1. The memory 570 may store a plurality of application programs running on the electronic apparatus 1, data for an operation of the electronic apparatus 1, and instructions. At least some of the plurality of applications may be downloaded from an external server through wireless communication. The memory 570 may store an application for an operation of the main processor 510, or may temporarily store input/output data, e.g., data such as a phonebook, messages, still images, and/or moving images. In some embodiments, the memory 570 may store haptic data for vibration of one or more suitable patterns provided to the haptic module 552, and audio data associated with one or more suitable sounds provided to the audio output unit 551.

The memory 570 may include a storage medium of at least one type (kind) from among a flash memory type (kind), a hard disk type (kind), a solid state disk (SSD) type (kind), a silicon disk drive (SDD) type (kind), a multimedia card micro type (kind), a card-type (kind) memory (e.g., secure digital (SD) or extreme digital (XD) memory), random access memory (RAM), static RAM (SRAM), read-only memory (ROM), electrically erasable programmable ROM (EEPROM), programmable ROM (PROM), magnetic memory, a magnetic disk, or an optical disk.

Under the control of the main processor 510, the power supply unit 580 may receive external power and/or internal power and supply power to each of elements included in the electronic apparatus 1. The power supply unit 580 may include the battery 80. In some embodiments, the power supply unit 580 may have a connection port, and the connection port may be configured as an example of the interface unit 560 to which an external charger supplying power for battery charging is electrically coupled. In embodiments, the power supply unit 580 may be configured to charge the battery 80 in a wireless manner. The battery 80 may be not to overlap the main circuit board 50 in the third direction (z-axis direction). The battery 80 may overlap the battery hole BH of the bracket 60.

The lower cover 90 may form the exterior shape of the electronic apparatus 1, and may have an opening that exposes a part of the display panel 10. The lower cover 90 may be assembled with the display panel 10 such that the display area of the display panel 10 is exposed through the opening of the lower cover 90. The lower cover 90 may be positioned such that the display panel 10 is interposed between the lower cover 90 and the cover window 70. The lower cover 90 may be below the main circuit board 50 and the battery 80. The lower cover 90 may be fastened and fixed to the bracket 60. The lower cover 90 may form the exterior shape of a lower part of the electronic apparatus 1. The lower cover 90 may include plastic, metal, or both plastic and metal.

A second camera hole CMH2 through which a lower surface of the camera 531 is exposed may be provided (e.g., formed) in the lower cover 90. A location of the camera 531 and positions of the first and second camera holes CMH1 and CMH2 corresponding to the camera 531 are not limited to the embodiments shown in FIGS. 1 and 2, and may be variously modified. For example, the camera 531 may be between the display panel 10 and the lower cover 90. In some embodiments, the camera 531 may overlap the opening area OA of the display area DA when viewed from a direction perpendicular to the display panel 10.

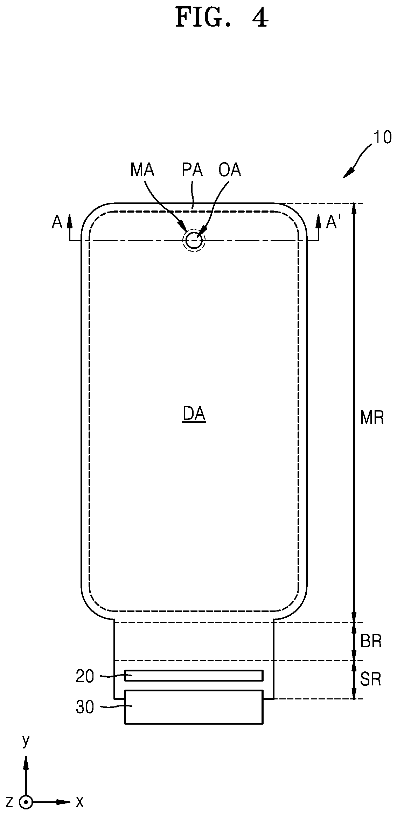

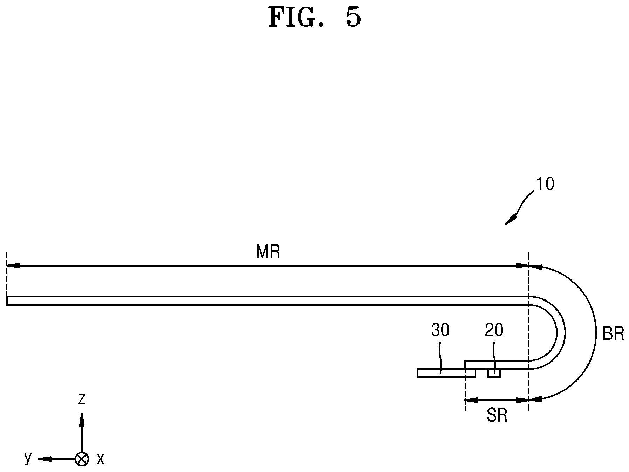

FIG. 4 is a plan view schematically illustrating the display panel 10 according to one or more embodiments, and FIG. 5 is a side view schematically illustrating the display panel 10 of FIG. 4. The electronic apparatus 1 described herein may include the display panel 10 shown in FIGS. 4 and 5.

The display panel 10 may include the display area DA and a peripheral area PA outside the display area DA. The display area DA is a portion in which an image is displayed, and a plurality of pixels may be in the display area DA. The display area DA may have one or more suitable shapes such as a circle, an ellipse, a polygon, and/or a set or specific shape. FIG. 4 shows that the display area DA has an approximately rectangular shape having round edges.

The peripheral area PA may be outside the display area DA. A width in the first direction (x-axis direction) of a portion of the peripheral area PA located at the bottom of the display area DA and extending in the first direction (x-axis direction) may be smaller than a width of the display area DA in the first direction (x-axis direction). This structure may make it easy for at least a part of the peripheral area PA to be bent.

A planar shape of the display panel 10 shown in FIG. 4 may be substantially identical to a shape of the substrate 100 included in the display panel 10. When it is described that the display panel 10 includes the display area DA and the peripheral area PA outside the display area DA, it may indicate that the substrate 100 includes the display area DA and the peripheral area PA outside the display area DA. Hereinbelow, for convenience of descriptions, it is described that the substrate 100 includes the display area DA and the peripheral area PA.

The display panel 10 may include a main area MR, a bending area BR outside the main area MR, and a sub-area SR spaced and/or apart (e.g., spaced apart or separated) from the main area MR with the bending area BR therebetween. The main area MR may be at one side of the bending area BR, and the sub-area SR may be on the other side of the bending area BR. The display panel 10 may be bent in the bending area BR, as shown in FIG. 5, and when viewed from the third direction (e.g., a z-axis direction), at least part of the sub-area SR may overlap the main area MR. FIG. 5 shows that the display panel 10 is bent, however, one or more embodiments are not limited thereto. In another embodiment, the display panel 10 may not be bent. In embodiments, the sub-area SR may be directly coupled to the main area MR. The sub-area SR may be a non-display area.

The data driver 20 may be in the sub-area SR of the display panel 10. The data driver 20 may be on the display panel 10 in the form of an IC. For example, the data driver 20 may be a data driving IC configured to generate data signals.

The display circuit board 30 may be affixed to an end of the sub-area SR of the display panel 10. The display circuit board 30 may be electrically coupled to the data driver 20 and/or the like through a pad of the sub-area SR of the display panel 10.

As described herein with reference to FIG. 2, the display panel 10 may have the opening area OA located within the display area DA. And the display panel 10 may have the intermediate area MA located between the display area DA and the opening area OA.

FIG. 6 is a cross-sectional view schematically illustrating a cross-section of the display panel 10 taken along line A-A' of FIG. 4. FIG. 6 shows not only the display panel 10 but also the cover window 70 and the camera 531 together, for convenience of illustrations. As described herein, the electronic apparatus 1 may include the display panel 10 and the camera 531 located in the opening area OA of the display panel 10.

The display panel 10 may include a substrate 100 having a first surface and a second surface opposite to (e.g., facing away from) each other, the display layer DIL over the first surface, which is an upper surface of the substrate 100 (in the +z direction), a polarization layer POL over the display layer DIL, and a bottom protective layer BPL on the second surface, which is the lower surface of the substrate 100. The display layer DIL may be disposed directly on the first surface of the substrate 100. The polarization layer may be disposed directly on the display layer DIL (in the +z-direction). The cover window 70 may be disposed directly on the polarization layer POL (in the +z-direction).

The display layer DIL may include display elements (or light-emitting elements) that emit light to display images. The display element may include a light-emitting diode, such as an organic light-emitting diode including an organic emission layer. In embodiments, the display element may be an inorganic light-emitting diode including inorganic materials. The inorganic light-emitting diode may include a PN diode including inorganic semiconductor-based materials. When a voltage is applied in a forward direction to a PN junction diode, holes and electrons may be injected, and energy generated by recombination of the holes and electrons may be converted into light energy so that light of a set or certain color is emitted. The aforementioned light-emitting diodes may have a width of several to several hundred micrometers, or several to several hundred nanometers.

One or more embodiments are not limited thereto. For example, the display layer DIL may include a quantum dot layer. For example, light generated from the emission layer included in the display layer DIL and having a wavelength belonging to a set or specific wavelength band may be converted into light of a preset wavelength by the quantum dot layer.

The display layer DIL may include, in addition to the display element, a driving circuit for driving the display element. The driving circuit may include, for example, a thin film transistor and a capacitor. The driving circuit may be below the display element.

The display layer DIL may also include a touchscreen layer. The touch screen layer included in the display layer DIL may obtain coordinate information according to an external input, such as a touch event. The touch screen layer may include sensing electrodes (or touch electrodes) and signal lines (trace lines) electrically coupled to the sensing electrodes. The touch screen layer may detect the external input in a mutual capacitance manner and/or a self-capacitance manner.

A touchscreen layer included in the display layer DIL may be over a display element. The touchscreen layer may be provided (e.g., formed) directly over the display element, or may be provided (e.g., formed) separately and then attached over the display element by an adhesive layer such as an optically transparent adhesive. In embodiments, the touch screen layer may be provided (e.g., formed) continuously after the process of providing the display element and the encapsulation layer protecting the display element, and in embodiments, the adhesive layer may not be interposed between the touch screen layer and the display element.

The polarization layer POL may have an anti-reflection function. If necessary, a phase retardation layer may be interposed between the polarization layer POL and the display layer DIL. The phase retardation layer may be, for example, a λ/4 wave plate. The phase retardation layer and polarization layer POL may reduce the reflectivity of light (external light) incident from the outside toward the display panel 10 through the cover window 70. When the display panel 10 includes the phase retardation layer, the polarization layer POL is regarded to include the phase retardation layer, in the following description.

The bottom protective layer BPL may be on, in particular directly on, the lower surface of the substrate 100 (in -z direction). The bottom protective layer BPL may include a material such as polyethylene terephthalate, polyethylene naphthalate, and/or polyimide. The bottom protective layer BPL may serve to protect the lower surface of the substrate 100. In embodiments, the bottom protective layer BPL may be opaque. In embodiments, the user may clearly view the image generated from the display layer DIL on the substrate 100. For this, the bottom protective layer BPL may include an opaque material, such as carbon black and/or the like.

To improve the transmittance of the opening area OA, the display panel 10 may include a through hole 10H. The through hole 10H may penetrate the substrate 100, the display layer DIL, the polarization layer POL, and the bottom protective layer BPL. For example, the substrate 100 may have a first hole H1, the display layer DIL and the polarization layer POL may have a second hole H2 that overlaps the first hole H1 when viewed from a direction perpendicular to the substrate 100, and the bottom protective layer BPL may have a third hole H3 that overlaps the first hole H1 when viewed from the direction perpendicular to the substrate 100, so that the through hole 10H penetrating through the substrate 100, the display layer DIL, the polarization layer POL, and the bottom protective layer BPL is provided (e.g., formed). At this time, an inner side surface of the second hole H2 of the display layer DIL and the polarization layer POL may be a continuous surface up to the upper surface of the substrate 100 (in the +z direction). If the inner side surface of the second hole H2 is a continuous surface up to the upper surface of the substrate 100, it may refer to that the inner side surface of the second hole H2 does not have a step up to the upper surface of the substrate 100. For reference, there may be a step between the second hole H2 of the display layer DIL and the polarization layer POL and the first hole H1 of the substrate 100. This will be described in more detail elsewhere herein. In such a display panel 10, an organic film may be excluded from (e.g., not exist on) the first surface, which is the upper surface of the substrate 100, between the display layer DIL and the first hole H1. This will also be described in more detail.

The cover window 70 may be over, in particular directly on, the display panel 10. The cover window 70 may be attached, e.g. directly attached, to the polarization layer POL by an adhesive layer including adhesive such as optically clear adhesive. The cover window 70 may cover the through hole 10H included in the display panel 10.

The opening area OA may be an area where the through hole 10H of the display panel 10 is located. In response to this opening area OA, an electronic element, such as the camera 531 or the component 40, may be placed (in the -z direction of the display panel 10). For example, the electronic element may overlap the opening area OA in the plan view. FIG. 6 shows that the camera 531 is positioned to correspond to the opening area OA as described herein. If necessary or desired, at least a portion of the camera 531 may be positioned within the through-hole 10H of the display panel 10.

### Method of manufacturing the display panel

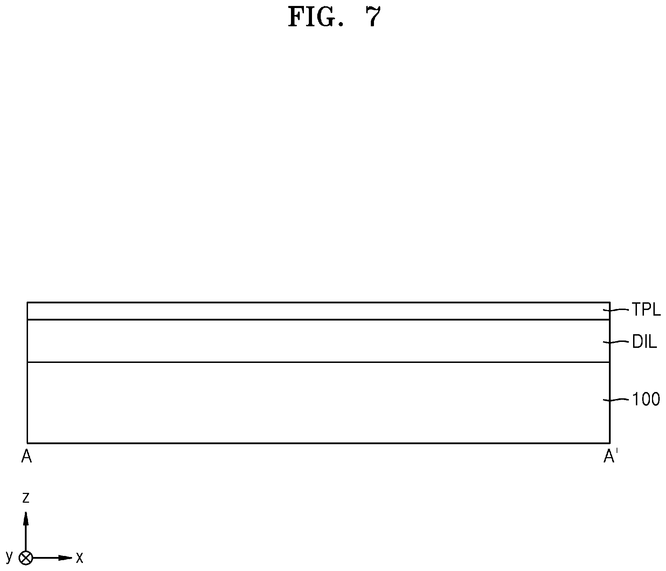

FIGS. 7 to 14 are cross-sectional views schematically illustrating steps for manufacturing the display panel 10 of FIG. 6.

The substrate 100 has suitable or sufficient thickness and has the first surface and the second surface opposite to (e.g., facing away from) each other. The thickness of the substrate 100 may be at least 1 micrometer, at least 10 micrometers, at least 20 micrometers, at least 50 micrometers or at least 100 micrometers and/or at most 1 millimeter, at most 900 micrometers, at most 750 micrometers, at most 500 micrometers or at most 250 micrometers. The display layer DIL is provided (e.g., formed) on, in particular directly on, the first surface, which is the upper surface of the substrate 100 (in the +z direction). The substrate 100 may include a glass substrate. A temporary protective layer TPL may be provided (e.g., formed) over and/or directly on an upper surface of the display layer DIL in a direction away from the substrate 100 (+z direction) to protect the upper surface of the display layer DIL. The temporary protective layer TPL may be provided (e.g., formed) using inkjet printing method and/or spin coating method. The temporary protective layer TPL may include polyethylene terephthalate, polyethylene naphthalate, and/or polyimide. In embodiments, the temporary protective layer TPL may be provided (e.g., formed) in advance in a form of a flat plate using the herein-mentioned material and then may be coupled (e.g., attached) to the display layer DIL using an adhesive. The temporary protective layer TPL protects the upper surface of the display layer DIL from being damaged during the manufacturing of the display panel 10.

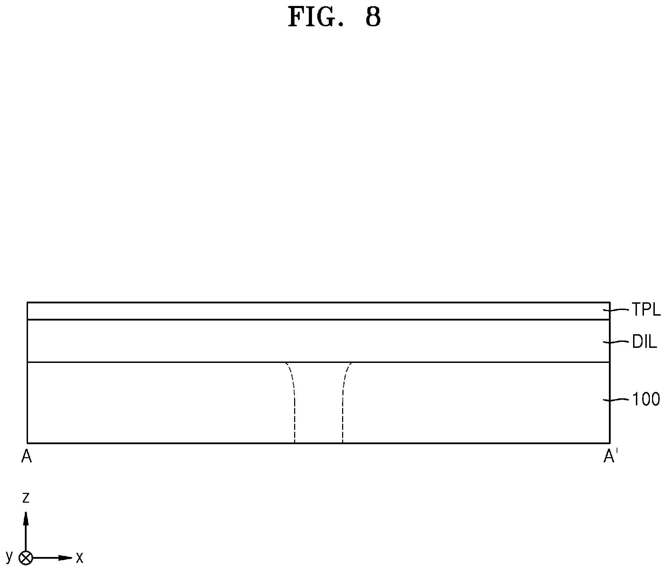

Then, as shown in FIG. 8, a scratch is provided (e.g., formed) inside the substrate 100. FIG. 8 indicates the scratch provided (e.g., formed) inside the substrate 100 with a dotted line. The area where the first hole H1 described herein is provided (e.g., formed) may be referred to as a hole-forming area. A portion of the substrate 100 where the scratch is provided (e.g., formed) may correspond to an edge of the hole-forming area. Because FIG. 8 is a cross-sectional view, the portion of the substrate 100 where the scratch is provided (e.g., formed) is indicated with two dotted lines, however, the scratch may be provided (e.g., formed) approximately uniformly in the substrate 100 to correspond to the edge of the hole-forming area. The scratch may be provided (e.g., formed) by irradiating a laser beam onto the substrate 100. For example, by focusing the laser beam at the portion within the substrate 100 where the scratch is to be provided (e.g., formed) and then irradiating the laser beam there, the scratch may be provided (e.g., formed) at the portion of the substrate 100. In other words, the scratch may be referred to a local weakening of the substrate 100 corresponding to the shape of the hole-forming area. The scratch may fully extend through the thickness of the substrate 100.

After providing the scratch within the substrate 100 in this manner, the second surface of the substrate 100, which is the lower surface of the substrate 100 (in -z direction), may be etched to reduce the thickness of the substrate 100 (e.g., such that the thickness of the substrate 100 becomes thinner). During the etching, the thickness of the substrate 100 may be reduced by at least 10 percent, at least 15 percent, at least 20 percent, at least 25 percent, at least 30 percent or at least 35 percent and/or at most 75 percent, at most 70 percent, at most 65 percent or at most 60 percent of the thickness of the substrate 100 prior to etching. In some embodiments, the thickness of the substrate 100 may be reduced by substantially 50 percent of the thickness of the substrate 100 prior to etching. When etching the lower surface of the substrate 100 to make the thickness of the substrate 100 thinner, a wet etching method using an etchant may be used. Any suitable solution that can etch glass may be used as the etchant. For example, an etchant including HF, HCL, phosphoric acid, and/or nitric acid may be used. For example, an etchant including 10 wt% HF, 40 wt% HNO₃, 40 wt% H₃PO₄, and 10 wt% deionized water (DI water) may be used, or an etchant including 20 wt% HF, 45 wt% HNO₃, 20 wt% H₃PO₄, and 15 wt% deionized water may be used.

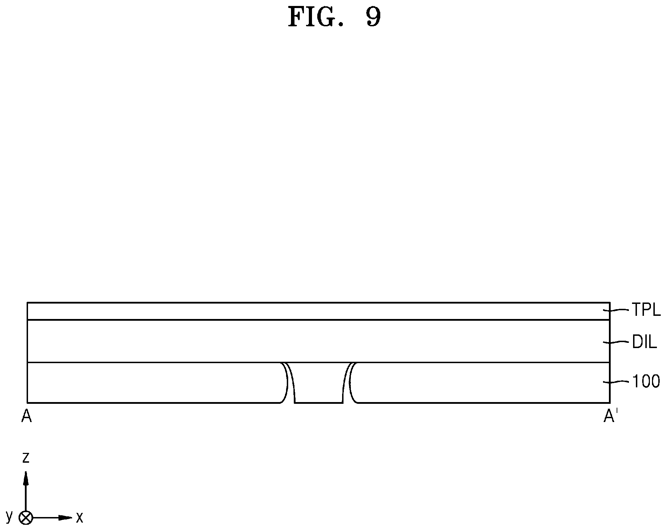

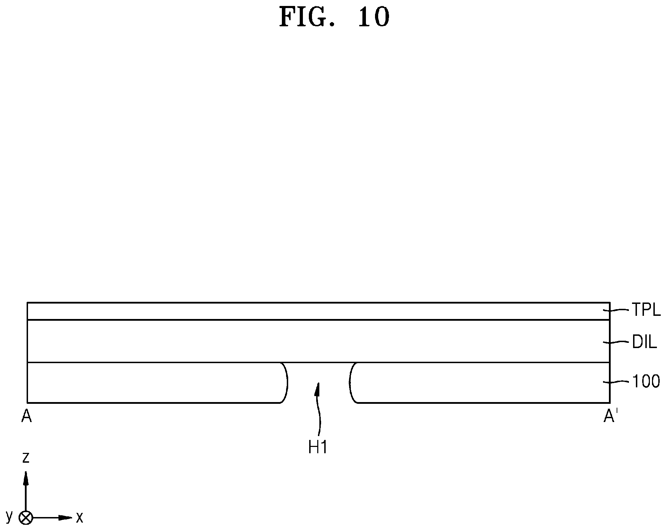

When etching the second surface which is the lower surface of the substrate 100 using the etchant, the etchant penetrates into the scratch provided (e.g., formed) within the substrate 100. Accordingly, the substrate 100 is etched along the scratch provided (e.g., formed) within the substrate 100. FIG. 9 shows that the thickness of the substrate 100 is reduced and the substrate 100 is etched along the edge of the hole-forming area by this way. In other words, due to the weakening of the substrate 100 in the hole-forming area, the etchant may penetrate deeper into the substrate 100 along the scratch, thereby enlarging the scratch along the x-direction. As the substrate 100 is etched along the edge of the hole-forming area, a portion of the substrate 100 corresponding to the portion where the first hole H1 is to be provided (e.g., formed) is separated from the remaining portion of the substrate 100, as shown in FIG. 9. Accordingly, when the portion separated from the remaining portion is removed, the first hole H1 is provided (e.g., formed) in the substrate 100 as shown in FIG. 10. Therefore, a portion of the lower surface of the display layer DIL corresponding to the first hole H1 of the substrate 100 is exposed. As the scratch is used to form the first hole H1 of the substrate 100, the shape of the scratch predefines the shape of the first hole H1. Therefore, the shape of the first hole H1 (or any further hole/s) may be easily varied by varying the shape of the scratch or by using a scratch pattern. For example, the shape of the desired hole, e.g. the first hole H1, may be round or rectangular when viewed in the z-direction. Examples for round shapes may be circle, ellipse (oval), semicircle, arc. sector (pie slice), lune (crescent shape) and annulus (ring shape - area between two concentric circles). Examples for rectangular shapes may be rectangle, square, parallelogram, rhombus, trapezoid and oblong (rectangle with unequal adjacent side). As explained above, the substrate 100 is etched from the second surface of the substrate 100. Therefore, when the first hole H1 is formed during the etching of the substrate 100, a portion of the substrate 100 closer to the second surface of the substrate 100 is relatively etched more than a portion of the substrate 100 closer to the first surface of the substrate 100. In consideration of this etch difference, the shape of the scratch may have the curved shape as shown in FIG. 8. For example, an area defined by the scratch at the second surface of the substrate 100 may be smaller than an area defined by the scratch at the first surface of the substrate 100.

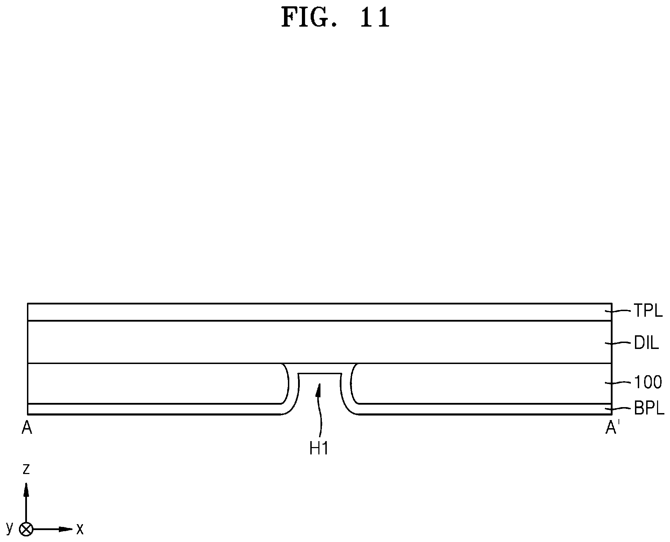

Thereafter, as shown in FIG. 11, the bottom protective layer BPL is provided (e.g., formed) on, in particular directly on, the second surface of the substrate 100, which is the lower surface of the substrate 100. For example, the bottom protective layer BPL is provided (e.g., formed) to cover the lower surface of the display layer DIL exposed by the first hole H1 of the substrate 100, the lower surface of the substrate 100, and the inner side surface of the first hole H1. The bottom protective layer BPL may be provided (e.g., formed) using an inkjet printing method and/or a spin coating method. In order to form the bottom protective layer BPL, if necessary, the display panel 10 being manufactured may be flipped over so that the lower surface of the substrate 100 is positioned in the +z direction from the upper surface of the substrate 100. The material for providing the bottom protective layer BPL is as described herein.

After providing the bottom protective layer BPL, the temporary protective layer TPL on the display layer DIL is removed. The temporary protective layer TPL may be removed in one or more suitable ways. For example, the temporary protective layer TPL may be removed by a wet etching method using an etchant, by a dry etching method, and/or by simply physically peeling the temporary protective layer TPL from the display layer DIL. If the temporary protective layer TPL is provided (e.g., formed) in advance in the form of the flat plate and is attached to the display layer DIL using the adhesive, the temporary protective layer TPL may be removed from the display layer DIL by making the adhesive to be less adhesive. For example, the temporary protective layer TPL may be removed by making the adhesive less adhesive by irradiating ultraviolet light onto the adhesive layer.

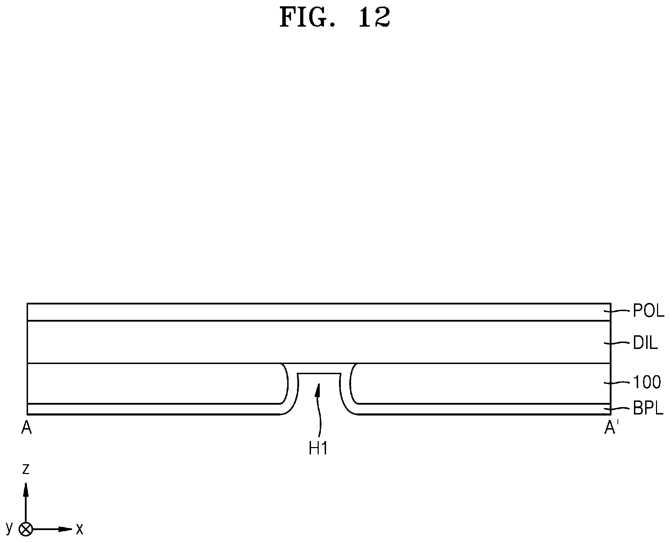

After removing the temporary protective layer TPL, the polarization layer POL may be provided (e.g., formed) over and/or directly on the display layer DIL to correspond to the entire surface of the display layer DIL, so that the display layer DIL is between the polarization layer POL and the substrate 100, as shown in FIG. 12. For example, the polarization layer POL may be provided (e.g., formed) in advance in a form of a flat plate and then may be attached to the display layer DIL using an adhesive. The polarization layer POL may be provided indirectly on the display layer DIL, i.e. with one or further other element/s or layer/s therebetween. If necessary, a phase retardation layer, such as a λ/4 wave plate, may be provided (e.g., formed) over and/or directly on the display layer DIL, and the polarization layer POL may be provided (e.g., formed) over and/or directly on the phase delay layer. When the display panel 10 includes the phase retardation layer, the polarization layer POL may be regarded to include the phase retardation layer as described herein, for convenience of descriptions. A phase retardation layer changes the polarization of light by introducing a phase shift between orthogonal polarization components. The phase retardation layer may be used to control or correct light behavior.

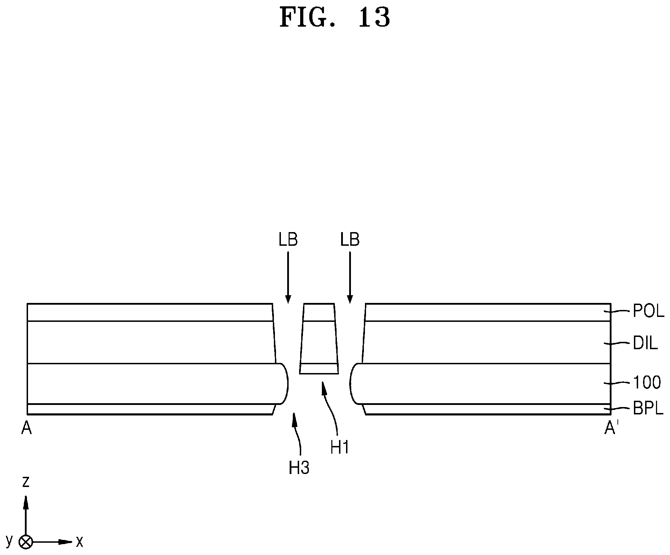

And then, as shown in FIG. 13, a portion of the polarization layer POL and the display layer DIL which corresponds to the edge of the hole-forming area is removed. For example, a laser beam LB is irradiated to a portion of the polarization layer POL corresponding to the edge of the hole-forming area, such that the corresponding portion of the polarization layer POL and the display layer DIL is removed. FIG. 13 is a cross-sectional view and thus shows two laser beams LB. However, the laser beams LB may be irradiated along the edge of the hole-forming area. The laser beam LB may be irradiated until a portion of the first surface, which is the upper surface of the substrate 100, corresponding to the edge of the hole-forming area, is exposed.

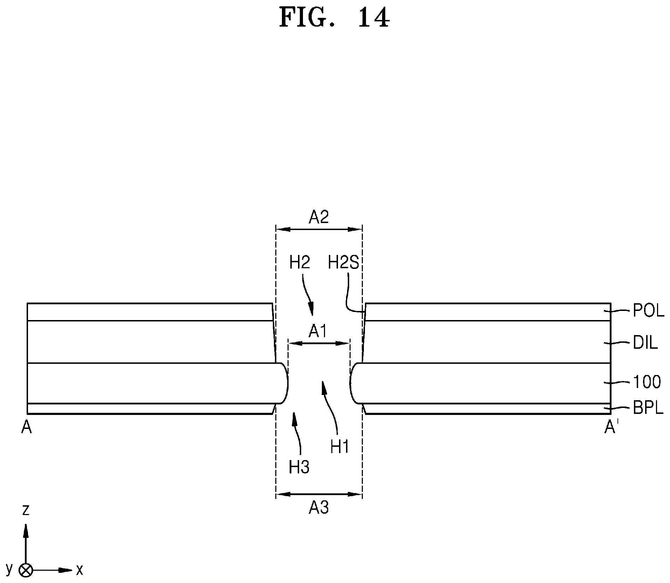

As the laser beam LB is irradiated along the edge of the hole-forming area, a portion of the display layer DIL and the polarization layer POL where the second hole H2 is to be provided (e.g., formed), is separated from the remaining portion of the display layer DIL and the polarization layer POL, as shown in FIG. 13. Accordingly, when the separated portion is removed, the second hole H2 coupled to the first hole H1 is provided (e.g., formed) in the display layer DIL and the polarization layer POL, as shown in FIG. 14.

In embodiments, when providing the second hole H2, the laser beam LB is irradiated onto the polarization layer POL and the substrate 100. In this process, a portion of the bottom protective layer BPL on the inner side surface of the first hole H1 may (also) be removed. In some embodiments, because the substrate 100 is transparent because it includes glass, the laser beam LB may pass through the substrate 100 and remove a portion of the bottom protective layer BPL on lower surface of the substrate 100 (in -z direction), as shown in FIGS. 13 and 14. Accordingly, the portion of the second surface of the substrate 100, which is the lower surface of the substrate 100, which is not covered by the bottom protective layer BPL and surrounds the first hole H1 may appear as a ring shape in the plan view. And the bottom protective layer BPL may have the third hole H3 corresponding to the first hole H1 of the substrate 100. However, the present disclosure is not limited to the ring shape. As already mentioned before, the shape may be round or rectangular. In other words, the second hole H2 and the third hole H3 may be simultaneously formed by irradiation of the laser beam LB. Thus, the shape of the second hole H2 and the third hole H3 may correspond to each other.

In some embodiments, when providing the second hole H2 in this way, the laser beam LB is irradiated to the polarization layer POL and the substrate 100 until or up to the first surface of the substrate 100, which is the upper surface of the substrate 100, corresponding to the edge of the hole-forming area is exposed, so that the organic film may be removed at least in the area of the first surface, which is the upper surface of the substrate 100, where the laser beam LB is irradiated. For example, in the display panel 10 manufactured as described herein, an organic film, such as an organic insulating film, may be excluded from (e.g., not exist on) the first surface, which is the upper surface of the substrate 100, between the display layer DIL and the first hole H1. For example, an organic film may be excluded from (e.g., not exist on) the first surface, which is the upper surface of the substrate 100, between the portion indicated as A1 and the portion indicated as A2 in FIG. 14.

As described herein, the second hole H2 is provided (e.g., formed) using the laser beam LB, and accordingly, the edge of the second hole H2 of the polarization layer POL may include a thermally deformed portion. Similarly, the edge of the third hole H3 of the bottom protective layer BPL may include a thermally deformed portion.

The second hole H2 of the display layer DIL and the polarization layer POL is provided (e.g., formed) by the laser beam LB, and thus the inner side surface H2S of the second hole H2 of the display layer DIL and the polarization layer POL may be a continuous surface up to the upper surface of the substrate 100. The inner side surface H2S of the second hole H2 being a continuous surface may refer to that the inner side surface H2S of the second hole H2 does not have a step up to the upper surface of the substrate 100. Accordingly, the area of the second hole H2 at the lower surface of the polarization layer POL in the direction to the display layer DIL may be equal to the area of the second hole H2 at the upper surface of the display layer DIL in the direction to the polarization layer POL.

There may be a step between the second hole H2 of the display layer DIL and the polarization layer POL and the first hole H1 of the substrate 100. This is because the second hole H2 of the display layer DIL and the polarization layer POL exposes the portion of the first surface, which is the upper surface of the substrate 100. The portion of the upper surface of the substrate 100 that is not covered by the display layer DIL and is exposed may have a shape surrounding the first hole H1 of the substrate 100, and accordingly, the portion may appear as a ring shape in the plan view. And the area A2 of the second hole H2 at the lower surface of the display layer DIL may be wider than the area A1 of the first hole H1 of the substrate 100 at the upper surface of the substrate 100. In other words, the size of the area A1 associated with the first hole H1 is predefined by the size enclosed by the scratch prior to the laser etching and the size of the area A2 associated with the second hole H2 is predefined by the size enclosed by the laser beam LB. For example, the size of the area A1 may be smaller than the size of the area A2 such that a step or a stepped section is formed between the first hole H1 and the second hole H2 (and/or the third hole H3). The step or stepped section may protrude towards a center of the first hole H1 and the second hole H2 (and/or the third hole H3) up to an amount of at least 5 percent, at least 7.5 percent, at least 10 percent, at least 12.5 percent or at least 15 percent of the size and/or the diameter of the second hole H2. The size of the area A2 may be greater than the size of the area A1 such that the entire of the display layer DIL and the polarization layer POL is supported by the substrate 100.

As described herein, the third hole H3 is provided (e.g., formed) in the bottom protective layer BPL by the laser beam LB irradiated to form the second hole H2, and the area of the third hole H3 of the bottom protective layer BPL may be wider than the area A1 of the first hole H1 of the substrate 100 at the upper surface of the substrate 100. Because the substrate 100 is transparent because it includes glass, the laser beam LB passes through the substrate 100, and a part of the bottom protective layer BPL on the lower surface of the substrate 100 is also removed, as shown in FIGS. 13 and 14. Because the third hole H3 is also provided (e.g., formed) concurrently (e.g., simultaneously) by the laser beam LB irradiated to form the second hole H2, the area A3 of the third hole H3 at the upper surface of the bottom protective layer BPL in the direction to the substrate 100 may be equal to the area A2 of the second hole H2 at the lower surface of the display layer DIL in the direction to the substrate 100. For example, when viewed in the direction perpendicular to the substrate 100 (z-axis direction), the edge of the third hole H3 at the upper surface of the bottom protective layer BPL may overlap the edge of the second hole H2 at the lower surface of the display layer DIL.

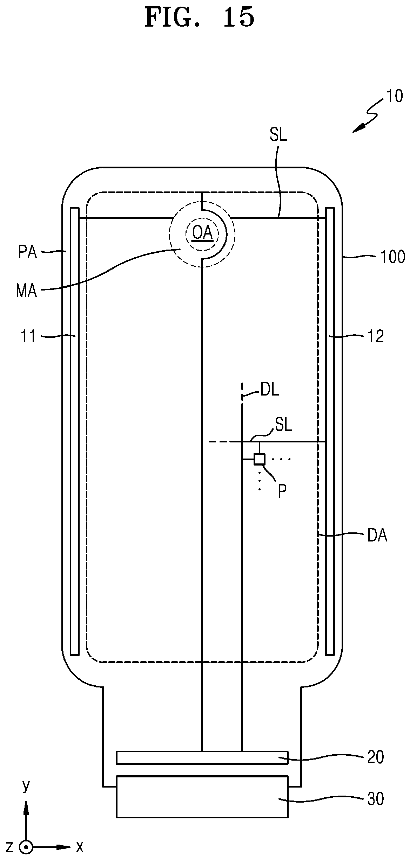

FIG. 15 is a plan view schematically illustrating the display panel 10 included in the electronic apparatus 1 of FIG. 1. As illustrated in FIG. 15 and as described herein, the display panel 10 may include the opening area OA, the intermediate area MA that may be referred to as the first area, the display area DA that may be referred to as the second area, and the peripheral area PA. For example, the substrate 100 of the display panel 10 may be regarded to include the first hole H1 corresponding to the opening area OA, the display area DA outside the first hole H1 and surrounding the first hole H1, the intermediate area MA between the first hole H1 and the display area DA, and the peripheral area PA outside the display area DA.

The display panel 10 may include a plurality of pixels P in a display area DA, and the display panel 10 may display an image using light emitted from the pixels P. Each of the pixels P may emit red light, green light, or blue light using a light-emitting diode. Pixels P may be electrically coupled to scan lines SL and data lines DL.

In the peripheral area PA, scan drivers 11 and 12 which may provide scan signals to each of pixels P, data drivers 20 which may provide data signals to each of pixels P, a first power line (e.g., the driving voltage line) for providing the driving voltage to each of pixels P, and a second power line for providing a common voltage (e.g., second power voltage) to each of pixels P may be provided.

The intermediate area MA may surround the opening area OA. The intermediate area MA may exclude (e.g., not have) display elements such as light-emitting diodes that emit light. Of course, if necessary, a display element may also be located in the intermediate area MA, and in embodiments, a pixel circuit electrically coupled to the display element may be located within the intermediate area MA or within the display area DA. Some of the signal lines that provide signals to pixels P located relatively adjacent to the opening area OA among the pixels P within the display area DA may pass through the intermediate area MA.

For example, the data line DL may cross the display area DA, but a portion of the data line DL may bypass the through hole 10H of the display panel 10 provided (e.g., formed) in the opening area OA, through the intermediate area MA along the edge of the through hole 10H. FIG. 15 shows that data lines DL cross the display area DA along the y-axis direction, but some data lines DL bypass the opening area OA, to partially surround the opening area OA in the intermediate area MA.

Some of scan lines SL may include a first portion and a second portion which extend across the display area DA along the x-axis and are separated from each other by the opening area OA. In embodiments, the first portion of the scan line SL located on one side (in -x direction) of the opening area OA may be electrically coupled to the scan driver 11 located on one side (in -x direction) of the opening area OA, and the second portion of the scan line SL located on the other side (in +x direction) of the opening area OA may be electrically coupled to the scan driver 12 located on the other side (in +x direction) of the opening area OA. Accordingly, scan lines SL may not need to bypass the opening area OA to partially surround the opening area OA through intermediate area MA. If the display panel 10 has only one scan driver, some scan lines SL may bypass the opening area OA to partially surround the opening area OA in the intermediate area MA.

FIG. 15 shows that the data driver 20 is placed on the substrate 100 so as to be adjacent to one edge of the substrate 100 (in -y direction), however, one or more embodiments are not limited thereto. For example, the data driver 20 may be on a printed circuit board that is electrically coupled to the display panel 10 through pads located at one edge of the display panel 10. And, as shown in FIG. 15, when the data driver 20 is located on the substrate 100 so as to be adjacent to one edge of the substrate 100 (in -y direction), a portion of the substrate 100 may be bent as described herein with reference to FIG. 5 so that the portion of the substrate 100 where the data driver 20, and/or the like, is positioned overlaps the display area DA and is positioned behind the display area DA.

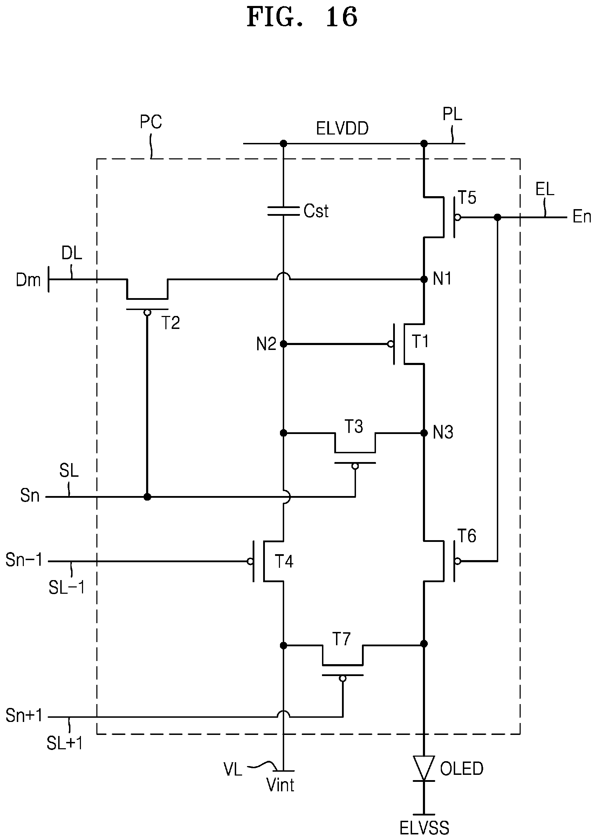

FIG. 16 is an equivalent circuit diagram of a pixel circuit PC electrically coupled to the light-emitting diode LED included in the display panel 10 of FIG. 15.

As shown in FIG. 16, the pixel circuit PC including a plurality of thin film transistors and a capacitor may be electrically coupled to the light-emitting diode LED. FIG. 16 shows that the pixel circuit PC includes seven thin film transistors T1 through T7 and a storage capacitor Cst. However, one or more embodiments may not be limited thereto, and the number of the thin film transistors and the capacitor and connection relationship therebetween may be suitably changed.

The plurality of thin film transistors T1 through T7 and the storage capacitor Cst may be coupled to signal lines SL, SL-1, SL+1, EL, and DL, an initialization voltage line VL and/or a driving voltage line PL. At least one of these lines, for example, the driving voltage line PL, may be shared by neighboring pixels P.

The plurality of thin-film transistors T1 through T7 may include a driving transistor T1, a switching transistor T2, a compensation transistor T3, a first initialization transistor T4, an operation control transistor T5, an emission control transistor T6, and a second initialization transistor T7.

The light-emitting diode LED, such as an OLED, may include a pixel electrode and an opposite electrode, the pixel electrode of the light-emitting diode LED may receive supply of a driving current by being coupled to the driving transistor T1 via the emission control transistor T6, and the opposite electrode may receive supply of a second power voltage ELVSS. The light-emitting diode LED may generate light having a luminance corresponding to the driving current.

Although FIG. 16 shows that all of the plurality of thin-film transistors T1 through T7 are P-channel metal-oxide-semiconductor field-effect transistors (MOSFETs) (PMOSs), one or more embodiments are not limited thereto. For example, each (e.g., all) of the plurality of thin-film transistors T1 through T7 may be N-channel MOSFETs (NMOSs). In embodiments, some of the plurality of thin-film transistors T1 through T7 may be PMOSs, whereas the others may be NMOSs. The plurality of thin-film transistors T1 through T7 may include amorphous silicon or polysilicon. In embodiments, at least some of the thin-film transistors T1 through T7 may include an oxide semiconductor.

The signal lines may include a scan line SL that transmits a scan signal Sn to the switching transistor T2 and the compensation transistor T3, a previous scan line SL-1 that transmits a previous scan signal Sn-1 to the first initialization transistor T4, a next scan line SL+1 that transmits a next scan signal Sn+1 to the second initialization transistor T7, an emission control line EL that transmits an emission control signal En to the operation control transistor T5 and the emission control transistor T6, and a data line DL that crosses the scan line SL and transmits a data signal Dm.

The driving voltage line PL may transmit a driving voltage ELVDD to the driving transistor T1, and the initialization voltage line VL may transmit an initialization voltage Vint that initializes the driving transistor T1 and initializes the pixel electrode of the light-emitting diode LED.

A driving gate electrode of the driving transistor T1 may be coupled to a first capacitor electrode of the storage capacitor Cst, one of a source region and a drain region of the driving transistor T1 may be coupled to the driving voltage line PL via the operation control transistor T5, and the other of the source region and the drain region of the driving transistor T1 may be electrically coupled to the pixel electrode of the light-emitting diode LED via the emission control transistor T6. The driving transistor T1 may supply the driving current to the light-emitting diode LED by receiving the data signal Dm in response to a switching operation of the switching transistor T2. For example, the driving transistor T1 may control an amount of current flowing through the light-emitting diode LED in response to a voltage changed by the data signal Dm.

A switching gate electrode of the switching transistor T2 may be coupled to the scan line SL that transmits the scan signal Sn, one of a source region and a drain region of the switching transistor T2 may be coupled to the data line DL, and the other of the source region and the drain region of the switching transistor T2 may be coupled to the driving transistor T1 and then may be coupled to the driving voltage line PL via the operation control transistor T5. The switching transistor T2 may transmit the data signal Dm from the data line DL to the driving transistor T1, in response to a voltage applied to the scan line SL. For example, the switching transistor T2 may be turned on in response to the scan signal Sn received through the scan line SL and may perform a switching operation of transmitting the data signal Dm, which is transmitted through the data line DL, to the driving transistor T1.

A compensation gate electrode of the compensation transistor T3 is coupled to the scan line SL. One of a source region and a drain region of the compensation transistor T3 may be coupled to the pixel electrode of the light-emitting diode LED via the emission control transistor T6. The other of the source region and the drain region of the compensation transistor T3 may be coupled to the first capacitor electrode of the storage capacitor Cst and the driving gate electrode of the driving transistor T1. The compensation transistor T3 may be turned on in response to the scan signal Sn received through the scan line SL and may cause the driving transistor T1 to be diode-coupled thereto.

A first initialization gate electrode of the first initialization transistor T4 may be coupled to the previous scan line SL-1. One of a source region and a drain region of the first initialization transistor T4 may be coupled to the initialization voltage line VL. The other of the source region and the drain region of the first initialization transistor T4 may be coupled to the first capacitor electrode of the storage capacitor Cst and the driving gate electrode of the driving transistor T1. For example, the first initialization transistor T4 may be turned on in response to the previous scan signal Sn-1 received through the previous scan line SL-1 and may perform an initialization operation of initializing a voltage of the driving gate electrode of the driving transistor T1 by transmitting the initialization voltage Vint to the driving gate electrode of the driving transistor T1.

An operation control gate electrode of the operation control transistor T5 may be coupled to the emission control line EL, one of a source region and a drain region of the operation control transistor T5 may be coupled to the driving voltage line PL, and the other may be coupled to the driving transistor T1 and the switching transistor T2.

An emission control gate electrode of the emission control transistor T6 may be coupled to the emission control line EL, one of a source region and a drain region of the emission control transistor T6 may be coupled to the driving transistor T1 and the compensation transistor T3, and the other of the source region and the drain region of the emission control transistor T6 may be electrically coupled to the pixel electrode of the light-emitting diode LED.

The operation control transistor T5 and the emission control transistor T6 are concurrently (e.g., simultaneously) turned on in response to the emission control signal En received through the emission control line EL and cause the driving voltage ELVDD to be transmitted to the light-emitting diode LED through the driving transistor T1, such that the driving current flows through the light-emitting diode LED.

A second initialization gate electrode of the second initialization transistor T7 may be coupled to the next scan line SL+1, one of a source region and a drain region of the second initialization transistor T7 may be coupled to the pixel electrode of the light-emitting diode LED, and the other of the source region and the drain region of the second initialization transistor T7 may be coupled to the initialization voltage line VL to receive supply of the initialization voltage Vint. The second initialization transistor T7 is turned on in response to the next scan signal Sn+1 received through the next scan line SL+1 and initializes the pixel electrode of the light-emitting diode LED. For reference, the next scan line SL+1 may be a scan line SL of a pixel that is adjacent to the pixel P shown in FIG. 16 and electrically coupled to the data line DL. For example, the scan line SL may transmit the same electrical signal with a time difference and function as a scan line SL of one pixel or function as a next scan line SL+1 of an adjacent pixel.

The storage capacitor Cst may include the first capacitor electrode and a second capacitor electrode. The first capacitor electrode of the storage capacitor Cst is coupled to the driving gate electrode of the driving transistor T1, and the second capacitor electrode of the storage capacitor Cst is coupled to the driving voltage line PL. The storage capacitor Cst may store an electric charge corresponding to a difference between the voltage of the driving gate electrode of the driving transistor T1 and the driving voltage ELVDD.

Detailed operations of each pixel P according to one or more embodiments are as follows.

During an initialization period, when the previous scan signal Sn-1 is supplied through the previous scan line SL-1, the first initialization transistor T4 is turned on, and the driving transistor T1 is initialized by the initialization voltage Vint supplied from the initialization voltage line VL.

During a data programming period, when the scan signal Sn is supplied through the scan line SL, the switching transistor T2 and the compensation transistor T3 are turned on. In embodiments, the driving transistor T1 is diode-coupled by the compensation transistor T3 that is turned on, and biased in a forward direction. Then, a compensation voltage (Dm+Vth, Vth has a negative value) that is obtained by subtracting a threshold voltage (Vth) of the driving transistor T1 from the data signal Dm supplied from the data line DL is applied to the driving gate electrode of the driving transistor T1. The driving voltage ELVDD and the compensation voltage (Dm+Vth) are applied to opposite ends of the storage capacitor Cst, and the storage capacitor Cst stores an electric charge corresponding to a difference between voltages at opposite ends thereof.

During an emission period, the operation control transistor T5 and the emission control transistor T6 are turned on in response to the emission control signal En supplied from the emission control line EL. The driving current is generated according to the difference between the voltage of the driving gate electrode of the driving transistor T1 and the driving voltage ELVDD, and the driving current is supplied to the light-emitting diode LED through the emission control transistor T6.

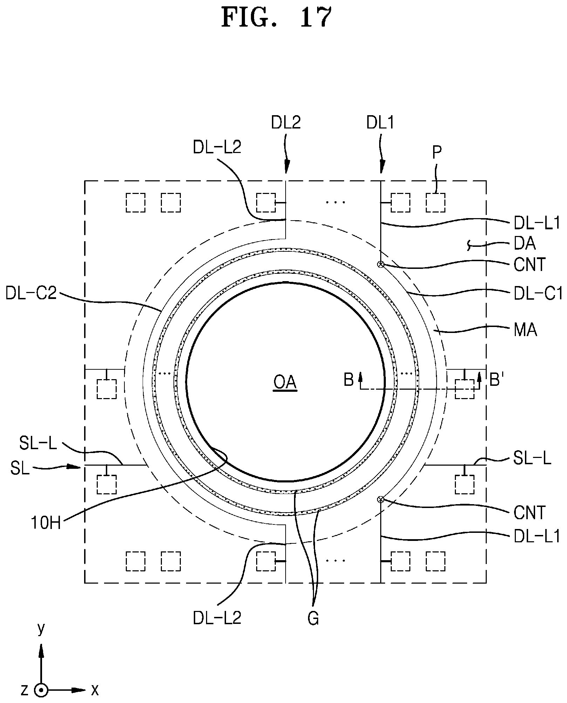

FIG. 17 is a plan view schematically illustrating the opening area OA, the intermediate area MA, and a portion of the display area DA of the display panel 10 of FIG. 15. As shown in FIG. 17, the pixels P are provided in the display area DA.

The intermediate area MA, which may be referred to as the first area, may be located between the opening area OA and the display area DA, which may be referred to as the second area. In a plan view, pixels P adjacent to the opening area OA may be spaced and/or apart (e.g., spaced apart or separated) from each other with respect to the opening area OA. For example, the pixels P may be spaced and/or apart (e.g., spaced apart or separated) in the vertical direction (y-axis direction) with respect to the opening area OA, or may be spaced and/or apart (e.g., spaced apart or separated) from each other in the left and right directions (x-axis direction) with respect to the opening area OA.

Among signal lines that supply signals to pixel circuits coupled to light-emitting diodes of respective pixels P, signal lines adjacent to the opening area OA may bypass the opening area OA and/or the through-hole 10H. Some of data lines DL passing through the display area DA are positioned in the same column, extend (in the y-axis direction) to provide data signals to pixels P positioned on one side (in a +y direction) of the opening area OA and pixels P positioned on the other side (in the -y direction) of the opening area OA, and may bypass the opening area OA and/or the through-hole 10H along edges of the opening area OA and/or through-hole 10H in the intermediate area MA.

FIG. 17 shows that a first data line DL1 includes a first extension portion DL-L1 electrically coupled to the pixels P positioned on one side (in the +y direction) of the opening area OA, a first extension portion DL-L1 electrically coupled to the pixels P positioned on the other side (in the -y direction) of the opening area OA, and a first bypass portion DL-C1 bypassing the opening area OA and/or the through-hole 10H along the edges of the opening area OA and/or the through-hole 10H in the intermediate area MA. The first bypass portion DL-C1 may electrically couple the two first extension portions DL-L1 spaced and/or apart (e.g., spaced apart or separated) from each other. As shown in FIG. 17, the first bypass portion DL-C1 may be substantially positioned on one side (in a +x direction) of the opening area OA. The first bypass portion DL-C1 may be positioned on a different layer from a layer on which the first extension portions DL-L1 are positioned, in which case, as shown in FIG. 17, the first bypass portion DL-C1 may be coupled to the first extension portions DL-L1 through contact holes CNT. Unlike this, in another embodiment, the first bypass portion DL-C1 and the first extension portions DL-L1 may also be integrally provided (e.g., formed).

FIG. 17 shows that a second data line DL2 includes a second extension portion DL-L2 electrically coupled to the pixels P positioned on one side (in the +y direction) of the opening area OA, a second extension portion DL-L2 electrically coupled to the pixels P positioned on the other side (in the -y direction) of the opening area OA, and a second bypass portion DL-C2 bypassing the opening area OA and/or the through-hole 10H along the edges of the opening area OA and/or the through-hole 10H in the intermediate area MA. The second bypass portion DL-C2 may electrically couple the two second extension portions DL-L2 spaced and/or apart (e.g., spaced apart or separated) from each other. As shown in FIG. 17, the second bypass portion DL-C2 may be substantially positioned on one side (in the -x direction) of the opening area OA. As shown in FIG. 17, the second bypass portion DL-C2 and the second extension portions DL-L2 may also be integrally provided (e.g., formed). In one or more embodiments, the second bypass portion DL-C2 may be positioned on a different layer from a layer on which the second extension portions DL-L2 are positioned, in which case the second bypass portion DL-C2 may be coupled to the second extension portions DL-L2 through contact holes.

The scan line SL may be separated or uncoupled with respect to the opening area OA. FIG. 17 shows that the scan line SL includes two sub-scan lines SL-L separated with respect to the opening area OA. A sub-scan line SL-L on the left side (in a -x direction) of the opening area OA may receive a signal from the scan driver 11 on the left side (in the -x direction) of the display area DA, and a sub-scan line SL-L on the right side (in the +x direction) of the opening area OA may receive a signal from the scan driver 12 on the right side (in the +x direction) of the display area DA. In one or more embodiments, these sub-scan lines SL-L may be electrically coupled to each other by a bypass portion in the intermediate area MA, and the display panel 10 may include one scan driver.

Grooves G may be positioned in the intermediate area MA. The grooves G may be between the opening area OA and an area where the data lines DL bypass. For example, the grooves G may be between the first bypass portion DL-C1 and the opening area OA and between the second bypass portion DL-C2 and the opening area OA. In the plan view viewed from the direction substantially perpendicular to a substrate (z-axis direction), each of the grooves G may have a closed loop shape surrounding the opening area OA. The grooves G may be spaced and/or apart (e.g., spaced apart or separated) from each other.

Fig. 18 is a cross-sectional view schematically illustrating a cross-section of the display panel 10 of Fig. 17 taken along line B-B'.

A buffer layer 201 may be over the substrate 100. The buffer layer 201 may prevent or reduce penetration of impurities into a semiconductor layer Act of the thin film transistor TFT. The buffer layer 201 may include an inorganic insulating material such as silicon nitride, silicon oxynitride, and/or silicon oxide, and may have a single-layer structure or a multi-layer structure.

The pixel circuit PC may be over the buffer layer 201. The pixel circuit PC may include the thin film transistor TFT and the storage capacitor Cst. The thin film transistor TFT may include the semiconductor layer Act, a gate electrode GE, a source electrode SE, and/or a drain electrode DE. The thin film transistor TFT shown in FIG. 18 may be the driving transistor. In the pixel circuit PC described herein with reference to FIG. 16, the emission control transistor T6 is interposed between the driving transistor T1 and the organic light-emitting diode OLED. In embodiments, unlike the structure shown in FIG. 18, the thin film transistor TFT, which is the driving transistor, is not coupled to the pixel electrode 221 of the organic light-emitting diode through the contact metal layer CM, but is electrically coupled to the emission control transistor, which is not shown in FIG. 18, and the emission control transistor may be electrically coupled to the pixel electrode 221 of the organic light-emitting diode. For convenience of descriptions, a structure in which the thin film transistor TFT of FIG. 18 is coupled to the pixel electrode 221 of the organic light-emitting diode through the contact metal layer CM is described.

The data line DL of the pixel circuit PC may be electrically coupled to the switching transistor included in the pixel circuit PC.

The semiconductor layer Act may include polysilicon. In embodiments, the semiconductor layer Act may include amorphous silicon, an oxide semiconductor material, an organic semiconductor material, and/or the like. The gate electrode GE may include a low-resistance metal material. For example, the gate electrode GE may include a conductive material including molybdenum (Mo), aluminum (Al), copper (Cu), and/or titanium (Ti), and may have a multi-layer structure or a single-layer structure. For example, the gate electrode GE may have a three-layer structure of a molybdenum layer, an aluminum layer, and a molybdenum layer (Mo/Al/Mo).

The gate insulating layer 203 between the semiconductor layer Act and the gate electrode GE may include an inorganic insulating material such as silicon oxide, silicon nitride, silicon oxynitride, aluminum oxide, titanium oxide, tantalum oxide, and/or hafnium oxide. The gate insulating layer 203 may have a single-layer structure or a multi-layer structure.

The source electrode SE and the drain electrode DE may be on the same layer as the data line DL and may include the same material as the data line DL. The source electrode SE, the drain electrode DE, and the data line DL may include a material having high conductivity. The source electrode SE and the drain electrode DE may include a conductive material including molybdenum (Mo), aluminum (Al), copper (Cu), titanium (Ti), and/or the like, and may have a multi-layer structure or a single-layer structure. For example, the source electrode SE, the drain electrode DE, and the data line DL may have a multi-layer structure of a titanium layer, an aluminum layer, and a titanium layer (Ti/Al/Ti).

FIG. 18 shows that the thin film transistor TFT includes both (e.g., simultaneously) the source electrode SE and the drain electrode DE, but one or more embodiments are not limited thereto. For example, the drain region of the semiconductor layer Act of the thin film transistor TFT may be integrally provided (e.g., formed) with a source region of a semiconductor layer of another thin film transistor, and in embodiments, the thin film transistor TFT may exclude (e.g., not have) the drain electrode DE and the other thin film transistor may exclude (e.g., not have) a source electrode. In embodiments, the circuit diagram may show the drain of a thin film transistor TFT as being coupled to the source of the other thin film transistor. In the pixel circuit PC shown in FIG. 16, the drain of the driving transistor T1 and the source of the emission control transistor T6 are shown to be coupled. In embodiments, the driving transistor T1 may exclude (e.g., not have) the drain electrode and the emission control transistor T6 may exclude (e.g., not have) the source electrode, and the drain region of the semiconductor layer of the driving transistor T1 and the source region of the emission control transistor T6 may be integrally provided (e.g., formed) as a single body. Similarly, in the pixel circuit PC shown in FIG. 16, because the source of the driving transistor T1 is coupled to the drain of the operation control transistor T5, the driving transistor T1 may exclude (e.g., not have) the source electrode and the operation control transistor T5 may exclude (e.g., not have) the drain electrode, and the source region of the semiconductor layer of the driving transistor T1 and the drain region of the operation control transistor T5 may be integrally provided (e.g., formed) as a single body. Accordingly, the driving transistor T1 may exclude (e.g., not have) both (e.g., simultaneously) the source electrode and the drain electrode.

The storage capacitor Cst may include the first capacitor electrode CE1 and the second capacitor electrode CE2 that overlap each other with a first interlayer insulating layer 205 therebetween. The storage capacitor Cst may overlap the thin film transistor TFT. FIG. 18 shows that the gate electrode GE of the thin film transistor TFT is the first capacitor electrode CE1 of the storage capacitor Cst. Of course, one or more embodiments are not limited thereto, and the storage capacitor Cst may not overlap the thin film transistor TFT. A second interlayer insulating layer 207 may cover the storage capacitor Cst. The second capacitor electrode CE2 of the storage capacitor Cst may include a conductive material including molybdenum (Mo), aluminum (Al), copper (Cu), and/or titanium (Ti), and may have a multi-layer structure or a single-layer structure.

The first interlayer insulating layer 205 and the second interlayer insulating layer 207 may include an inorganic insulating material such as silicon oxide, silicon nitride, silicon oxynitride, aluminum oxide, titanium oxide, tantalum oxide, and/or hafnium oxide. The first interlayer insulating layer 205 and the second interlayer insulating layer 207 may have a single-layer structure or a multi-layer structure.

A first organic insulating layer 209 may cover the pixel circuit PC including the thin film transistor TFT and the storage capacitor Cst.

The pixel circuit PC may be electrically coupled to the pixel electrode 221. For example, as shown in FIG. 18, the contact metal layer CM may be interposed between the thin film transistor TFT and the pixel electrode 221. The contact metal layer CM may be coupled to the thin film transistor TFT through a contact hole defined in the first organic insulating layer 209, and the pixel electrode 221 may be coupled to the contact metal layer CM through a contact hole defined in the second organic insulating layer 211 covering the contact metal layer CM. The contact metal layer CM may include a conductive material including molybdenum (Mo), aluminum (Al), copper (Cu), and/or titanium (Ti), and may have a multi-layer structure or a single-layer structure. For example, the contact metal layer CM may have a multi-layer structure of a titanium layer, an aluminum layer, and a titanium layer (Ti/Al/Ti).

The first organic insulating layer 209 and the second organic insulating layer 211 may include an organic insulating material such as acrylic, polystyrene (PS), polymethylmethacrylate (PMMA), BCB (Benzocyclobutene), polyimide, and/or HMDSO (Hexamethyldisiloxane). For example, the first organic insulating layer 209 and the second organic insulating layer 211 may include polyimide. The first organic insulating layer 209 and/or the second organic insulating layer 211 may have a substantially flat upper surface. For example, the first organic insulating layer 209 and/or the second organic insulating layer 211 may be referred to as a planarization layer.

The pixel electrode 221 on the second organic insulating layer 211 may be a (semi)transparent electrode or a reflective electrode. For example, the pixel electrode 221 may include a reflective layer including Ag, Mg, Al, Pt, Pd, Au, Ni, Nd, Ir, Cr or a compound thereof, and a transparent or semitransparent electrode layer on the reflective layer. The transparent or semitransparent electrode layer may include at least one selected from the group consisting of indium tin oxide (ITO), indium zinc oxide (IZO), zinc oxide (ZnOₓ: ZnO or ZnO₂), indium oxide (In₂O₃), indium gallium oxide (IGO), and aluminum zinc oxide (AZO). For example, the pixel electrode 221 may have a three-layer structure of ITO/Ag/ITO.

A pixel-defining layer 215 may be over the second organic insulating layer 211. The pixel-defining layer 215 may prevent or reduce occurrence of arcs and/or the like at the edge of the pixel electrode 221 by covering the edge of the pixel electrode 221 and increasing the distance between the pixel electrode 221 and the common electrode 223 above the pixel electrode 221. For example, the pixel-defining layer 215 has an opening to expose the central portion of the pixel electrode 221. The pixel-defining layer 215 may be provided (e.g., formed) by a method such as spin coating and may include one or more organic insulating materials selected from the group consisting of polyimide, polyamide, acrylic resin, benzocyclobutene, and phenol resin. in embodiments, the pixel-defining layer 215 may include an inorganic insulating material such as silicon nitride (SiNx), silicon oxynitride (SiON), and/or silicon oxide (SiOx).

An intermediate layer 222 interposed between the pixel electrode 221 and the common electrode 223 may include an emission layer 222b. The intermediate layer 222 may include a first functional layer 222a between the emission layer 222b and the pixel electrode 221, or may include a second functional layer 222c between the emission layer 222b and the common electrode 223. The emission layer 222b may emit light of a predetermined color and may include a polymer or low-molecular organic material.

The first functional layer 222a may have a single-layer structure or a multi-layer structure. For example, when the first functional layer 222a includes a polymer material, the first functional layer 222a may have a single-layer structure including a hole transport layer (HTL) and may include polyethylene dioxythiophene (PEDOT: poly-(3,4)-ethylene-dioxy thiophene) and/or polyaniline (PANI: polyaniline). When the first functional layer 222a includes a low-molecular-weight material, the first functional layer 222a may include a hole injection layer (HIL) and the hole transport layer (HTL).

The second functional layer 222c may include an electron transport layer (ETL) and/or an electron injection layer (EIL).

In some embodiments, unlike the structure shown in FIG. 18, the intermediate layer 222 may include a first stack including an emission layer 222b and a functional layer, a second stack including an emission layer 222b and a functional layer, and a charge generation layer between the first stack and the second stack. The charge generation layer may include a negative charge generation layer and a positive charge generation layer. The emission efficiency of a tandem organic light-emitting diode OLED having a plurality of emission layers may be further increased by the negative charge generation layer and the positive charge generation layer.

The negative charge generation layer may be an n-type (kind) charge generation layer. The negative charge generation layer may supply electrons. The negative charge generation layer may include a host and a dopant. The host may include an organic material. The dopant may include a metal material. The positive charge generation layer may be a p-type (kind) charge generation layer. The positive charge generation layer may supply holes. The positive charge generation layer may include a host and a dopant. The host may include an organic material. The dopant may include a metal material.

The emission layer 222b may have a patterned shape corresponding to the pixel electrode 221. Layers included in the intermediate layer 222 other than the emission layer 222b may be provided (e.g., formed) in one or more suitable ways. For example, a layer included in the intermediate layer 222 other than the emission layer 222b may be integrally provided (e.g., formed) as a single body throughout the plurality of pixel electrodes 221. Layers included in the intermediate layer 222 other than the emission layer 222b may also be located in the intermediate area MA.

The common electrode 223 may be a light-transmitting electrode or a reflective electrode. For example, the common electrode 223 may be a transparent or semitransparent electrode and may include a metal film having a small work function including Li, Ca, Al, Ag, Mg and/or a compound thereof (e.g., LiF). In one or more embodiments, the common electrode 223 may further include a TCO (transparent conductive oxide) film such as ITO, IZO, ZnO, ZnO₂ and/or In₂O₃ on the metal film.

The common electrode 223 may be provided (e.g., formed) as a single body over the entire display area DA to cover the display area DA, and may be over the intermediate layer 222 and the pixel-defining layer 215. For example, each of the pixel electrodes 221 may correspond to each light-emitting diode LED, and the common electrode 223 may be integrally provided (e.g., formed) as a single body to correspond to the plurality of organic light-emitting diodes OLEDs. The plurality of organic light-emitting diodes OLEDs may share the common electrode 223, and a laminated structure of the pixel electrode 221, the intermediate layer 222, and the common electrode 223 may correspond to the organic light-emitting diode OLED.

The capping layer 230 may be over the common electrode 223. For example, the capping layer 230 may include LiF. In embodiments, the capping layer 230 may not be provided.

A spacer 217 may be on the pixel-defining layer 215. The spacer 217 may include an organic insulator such as polyimide. In embodiments, the spacer 217 may include an inorganic insulator, or may include an organic insulator and an inorganic insulator.

The spacer 217 may include a material different from the material of the pixel-defining layer 215 or may include the same material as the pixel-defining layer 215. For example, the pixel-defining layer 215 and the spacer 217 may include polyimide. When the pixel-defining layer 215 and the spacer 217 include the same material, the pixel-defining layer 215 and the spacer 217 may be provided (e.g., formed) concurrently (e.g., simultaneously) in one mask process using a halftone mask. Among the aforementioned intermediate layers 222, the functional layers or the common electrodes 223 may cover the spacer 217.

A thin film encapsulation layer 300 may cover the organic light-emitting diode OLED. The thin film encapsulation layer 300 may include at least one organic encapsulation layer and at least one inorganic encapsulation layer, and FIG. 18 shows that the thin film encapsulation layer 300 includes a first inorganic encapsulation layer 310, a second inorganic encapsulation layer 330, and an organic encapsulation layer 320 interposed therebetween. In embodiments, the number of organic and inorganic encapsulating layers and the stacking order may be changed.

Each of the first inorganic encapsulation layer 310 and the second inorganic encapsulation layer 330 may include one or more inorganic materials selected from aluminum oxide, titanium oxide, tantalum oxide, hafnium oxide, zinc oxide, silicon oxide, silicon nitride, and silicon oxynitride. Each of the first inorganic encapsulation layer 310 and the second inorganic encapsulation layer 330 may have a single-layer structure or a multi-layer structure. The organic encapsulation layer 320 may include a polymer material. The polymer material may include acrylic resins such as polymethyl methacrylate and/or polyacrylic acid, epoxy resins, polyimides, and/or polyethylene. For example, the organic encapsulation layer 320 may include acrylate.

The first inorganic encapsulation layer 310 and the second inorganic encapsulation layer 330 may include different materials. For example, the first inorganic encapsulation layer 310 may include silicon oxynitride, and the second inorganic encapsulation layer 330 may include silicon nitride.

An additional planarization layer SPL may be over the thin film encapsulation layer 300, and the polarization layer POL may be on the additional planarization layer SPL. The additional planarization layer SPL is a part of the aforementioned display layer DIL and may include an organic insulating material such as acrylic, polystyrene (PS), polymethylmethacrylate (PMMA), benzocyclobutene (BCB), polyimide, and/or hexamethyldisiloxane (HMDSO). The additional planarization layers SPL may be provided (e.g., formed) by an inkjet printing method and/or a spin coating method. The additional planarization layer SPL may have a substantially flat upper surface. If the display layer DIL includes a touch screen layer over the thin film encapsulation layer 300, an additional planarization layer SPL may be over the touch screen layer.

As described herein and as shown in FIG. 18, the inner side surface H2S of the second hole H2 included in the display layer DIL and the polarization layer POL may be a continuous surface up to the upper surface of the substrate 100. For example, in the polarization layer POL, the additional planarization layer SPL, the second interlayer insulating layer 207, the first interlayer insulating layer 205, the gate insulating layer 203, and/or the buffer layer 201, the inner side surface H2S of the second hole H2 may form a continuous surface without a step.

The intermediate area MA shown in FIG. 18 may include a first sub-intermediate area SMA1 and a second sub-intermediate area SMA2. The first sub-intermediate area SMA1 may be relatively farther from the opening area OA where the through hole 10H of the display panel 10, e.g., the first hole H1 of the substrate 100 exists, than the second sub-intermediate area SMA2. In embodiments, the second sub-intermediate area SMA2 is closer to the opening area OA than the first sub-intermediate area SMA1. The lines and grooves G1, G2, and G that bypass the opening area OA may be provided in the intermediate area MA.

Lines, such as data lines DL, may be provided in the first sub-intermediate area SMA1. The data lines DL in the first sub-intermediate area SMA1 shown in FIG. 18 correspond to the bypass portions of the data lines DL described herein with reference to FIG. 17, such as the first bypass portion DL-C1 and/or the second bypass portion DL-C2. The first sub-intermediate area SMA1 may be a line area or bypass area through which lines such as data lines DLs bypass.

In the first sub-intermediate area SMA1, data lines DL may be provided alternately with an insulating layer between them. For example, one of the neighboring data lines DL may be below the insulating layer (e.g., the first organic insulating layer, 209) and the other may be on the insulating layer (e.g., the first organic insulating layer, 209). When data lines DL are provided alternately with an insulating layer between them, the distance (Δd, pitch) between neighboring data lines in the plan view may be reduced. FIG. 18 shows data lines DL located in the first sub-intermediate area SMA1. However, if necessary or desired, bypass portions of the scan lines SL may also be located in the first sub-intermediate area SMA1.

The grooves G1, G2, and G may be provided in the second sub-intermediate area SMA2. The organic layer included in the intermediate layer 222, such as the first functional layer 222a and/or the second functional layer 222c, may be uncoupled (or separated) by the grooves G1, G2, and G. The second sub-intermediate area SMA2 may be referred to as a disconnection area (or separation area) of the organic layer or a groove area.

The grooves G1, G2, and G may be provided (e.g., formed) by a layer interposed between the substrate 100 and the organic light-emitting diode OLED which is a display element. FIG. 18 shows that the first organic insulating layer 209, which may be referred to as an upper layer, is over the second interlayer insulating layer 207, which may be referred to as a lower layer, and the first organic insulating layer 209 includes the grooves G1, G2, and G. If necessary or desired, each of the grooves G1, G2, and G may be provided (e.g., formed) through a plurality of layers (for example, through the upper layer and the lower layer).

Among the grooves G1, G2, and G in the intermediate area MA which may be referred to as the first area, the first groove G1, which is the groove closest to the opening area OA where the first hole H1 of the substrate 100 is located, may be provided (e.g., formed) in the first upper layer 209a on the second interlayer insulating layer 207, which may be referred to as the lower layer. The first upper layer 209a may be a part of the first organic insulating layer 209. In embodiments, during the manufacturing process, the first upper layer 209a may be provided (e.g., formed) concurrently (e.g., simultaneously) with the first organic insulating layer 209 and have the same material, with the first upper layer 209a being spaced and/or apart (e.g., spaced apart or separated) from the first organic insulating layer 209. The first groove G1 may extend along at least a portion of the opening area OA, or may extend along the opening area OA to completely surround the opening area OA, as described herein with reference to FIG. 17. Materials for providing the intermediate layer 222, the common electrode 223, and the capping layer 230 may be positioned within the first groove G1. This may also apply to other grooves to be described herein.

A first-1 metal layer M1-1 may be positioned to extend over the second interlayer insulating layer 207, which may be referred to as the lower layer, and the first upper layer 209a. The first-1 metal layer M1-1 may be provided (e.g., formed) simultaneously with the contact metal layer CM with the same material during the manufacturing process. The first-1 metal layer M1-1 may be located in a direction to the opening area OA (-x direction) where the through hole 10H is located, with respect to the center of the first groove G1 of the first upper layer 209a. One end of the first-1 metal layer M1-1 in the direction to the opening area OA (-x direction) is on the second interlayer insulating layer 207, which may be referred to as the lower layer, and the other end of the first-1 metal layer M1-1 in a direction to the center of the first groove G1 may protrude from the first upper layer 209a and be located within the first groove G1.

In some embodiments, a first-2 metal layer M1-2, which is apart from the first-1 metal layer M1-1, may be over the second interlayer insulating layer 207, which may be referred to as the lower layer, and over the first upper layer 209a, so as to be positioned in the direction to the second area which is the display area DA (+x direction), with respect to the center of the first groove G1. One end of the first-2 metal layer M1-2 in the direction to the center of the first groove G1 may protrude from the first upper layer 209a and be located within the first groove G1.

In embodiments, because the end of the first-1 metal layer M1-1 in the direction to the center of the first groove G1 protrudes from the first upper layer 209a and is located within the first groove G1, and because the end of the first-2 metal layer M1-2 in the direction to the center of the first groove G1 protrudes from the first upper layer 209a and is located within the first groove G1, in the structure of the set of the first upper layer 209a, the first-1 metal layer M1-1, and the first-2 metal layer M1-2, the first groove G1 may be regarded as having an undercut structure. A portion of the first-1 metal layer M1-1 protruding from the first upper layer 209a may be referred to as a protruding tip, and the length of the protruding tip protruding from the first upper layer 209a may be about 0.3 micrometer (um) to about 0.5 um. For example, the length of the protruding tip may be about 0.4 um. The length of a protruding tip which is a portion of the first-2 metal layer and protrudes from the first upper layer 209a may also be about 0.3 um to about 0.5 um. For example, the length of the protruding tip may be about 0.4 um.

As described herein, the functional layer included in the intermediate layer 222 may be provided (e.g., formed) to approximately correspond to the entire surface of the substrate 100, and then a portion of the substrate 100 or the like may be removed to form the through hole 10H in the display panel 10. Accordingly, moisture from the outside that penetrates into the functional layer through the through hole 10H may move along the functional layer to the display area DA and may cause defects. However, in the display panel 10 according to one or more embodiments and the electronic apparatus 1 including the same, as described herein, the first groove G1 having the undercut structure may be provided (e.g., formed) before the intermediate layer 222 is provided (e.g., formed) during the manufacturing process. Accordingly, the functional layer included in the intermediate layer 222 may be uncoupled by the first groove G1 having the undercut structure as shown in FIG. 18, and thus, even if moisture penetrates into the functional layer through the through hole 10H, it is possible to prevent, minimize, or reduce movement of the moisture toward the display area DA.

As described herein, in the display panel 10 according to one or more embodiments, an organic film, such as an organic insulating film, may not exist on the first surface, which is the upper surface of the substrate 100, between the display layer DIL and the opening area OA, for example, between the display layer DIL and the first hole H1. For example, FIG. 18 shows that no organic film, such as an organic insulating film, exists on the first surface, which is the upper surface of the substrate 100, between the inner side surface H2S of the second hole H2 and the opening area OA. Through this structure, it is possible to effectively prevent, minimize, or reduce penetration of moisture from the outside, such as moisture that penetrates through the through hole 10H, into the functional layer.

As described herein, in embodiments of the first-1 metal layer M1-1 located in the direction to the opening area OA (-x direction) with respect to the center of the first groove G1, which is the groove closest to the opening area OA, the end of the first-1 metal layer M1-1 in the direction to the opening area OA (-x direction) may be on the second interlayer insulating layer 207, which may be referred to as the lower layer. The bonding force between the first-1 metal layer M1-1 including metal and the inorganic insulator is stronger than the bonding force between the first-1 metal layer M1-1 including metal and the organic insulator. As described herein, because the second interlayer insulating layer 207 includes an inorganic insulating material, the end of the first-1 metal layer M1-1 in the direction to the opening area OA (-x direction) may be strongly bonded to the second interlayer insulating layer 207. This may prevent, minimize, or reduce defects such as delamination between layers near the opening area OA.

Among the grooves G1, G2, and G existing in the intermediate area MA which may be referred to as the first area, the second groove G2, which is the second closest to the opening area OA where the through hole of the substrate 100 is located, may be provided (e.g., formed) in the second upper layer 209b on the second interlayer insulating layer 207, which can be referred to as the lower layer. The second upper layer 209b may be a part of the first organic insulating layer 209. In embodiments, the second upper layer 209b may be provided (e.g., formed) concurrently (e.g., simultaneously) with the first organic insulating layer 209 during the manufacturing process using the same material, but may be apart from the first organic insulating layer 209 so as to be located between the display area DA and the first upper layer 209a. The second upper layer 209b may be separated from the first upper layer 209a. The second groove G2 may extend along at least a portion of the opening area OA, or may extend around to completely surround the opening area OA as described herein with reference to FIG. 17.

A second-1 metal layer M2-1 may be over the second upper layer 209b and over the second interlayer insulating layer 207 which may be referred to as the lower layer. The second-1 metal layer M2-1 may be provided (e.g., formed) concurrently (e.g., simultaneously) with the contact metal layer CM using the same material during the manufacturing process. This second-1 metal layer M2-1 may be located in the direction to the opening area OA (-x direction) where the through hole 10H is located, with respect to the center of the second groove G2 of the second upper layer 209b. One end of the second-1 metal layer M2-1 in the direction to the center of the second groove G2 may protrude from the second upper layer 209b and be located within the second groove G2.

A second-2 metal layer M2-2, which is apart from the second-1 metal layer M2-1, may be over the second interlayer insulating layer 207 which may be referred to as the lower layer and over the second upper layer 209b, so as to be located in the direction to the display area DA, which is the second area, with respect to the center of the second groove G2. One end of the second-2 metal layer M2-2 in the direction to the center of the second groove G2 may protrude from the second upper layer 209b and be located within the second groove G2.

In embodiments, because the end of the second-1 metal layer M2-1 in the direction to the center of the second groove G2 protrudes from the second upper layer 209b and is located within the second groove G2, and because the end of the second-2 metal layer M2-2 in the direction to the center of the second groove G2 protrudes from the second upper layer 209b and is located within the second groove G2, in the structure of the set of the second upper layer 209b, the second-1 metal layer M2-1, and the second-2 metal layer M2-2, the second groove G2 may be regarded as having an undercut structure. A portion of the second-1 metal layer M2-1 protruding from the second upper layer 209b may be referred to as a protruding tip, and the length of the protruding tip protruding from the second upper layer 209b may be about 1.7 um. The length of a protruding tip which is a portion of the second-2 metal layer M2-2 and protrudes from the second upper layer 209b may also be about 1.7 um.

As described herein, the functional layer included in the intermediate layer 222 may be uncoupled by the first groove G1 having the undercut structure, and similarly, may be uncoupled by the second groove G2 having the undercut structure. Accordingly, even if moisture penetrates into the functional layer exposed to the outside at the inner side surface of the through hole 10H, movement of the moisture toward the display area DA may be effectively prevented, minimized, or reduced.

As illustrated in FIG. 18, the first-2 metal layer M1-2 and the second-1 metal layer M2-1 may be integrally provided (e.g., formed) as a single body. Therefore, the first-2 metal layer M1-2 and the second-1 metal layer M2-1 each of which is a part of the single body may contact the second interlayer insulating layer 207, which is the lower layer, between the first upper layer 209a and the second upper layer 209b. The metal layer and the second interlayer insulating layer 207 that are in contact with each other between the first upper layer 209a and the second upper layer 209b may form an inorganic contact region ICR with strong bonding force. In embodiments, as described herein, the end of the first-1 metal layer M1-1 in the direction to the opening area OA (-x direction) may also contact the second interlayer insulating layer 207 to form an inorganic contact area ICR with strong bonding strength.

Similarly as the functional layers, the common electrode 223 may also be uncoupled in the first groove G1 and in the second groove G2. The capping layer 230 including LiF, and/or the like may also be uncoupled in the first groove G1 and in the second groove G2. If the capping layer 230 includes an inorganic material such as silicon nitride, silicon oxide and/or silicon oxynitride, the capping layer 230 may be provided (e.g., formed) continuously without being uncoupled by the first groove G1 and/or the second groove G2. For convenience of description, the following description will describe an embodiments where the capping layer 230 is uncoupled by the first groove G1 and the second groove G2.

A first partitioning wall PW1 and a second partitioning wall PW2 may be located in the intermediate area MA. Although FIG. 18 shows that the first partitioning wall PW1 and the second partitioning wall PW2 are located in the intermediate area MA, one or more embodiments are not limited thereto. For example, three partitioning walls may be located in the intermediate area MA. The first partitioning wall PW1 may be located closer to the display area DA than the second partitioning wall PW2. Each of the first partitioning wall PW1 and the second partitioning wall PW2 may extend along the opening area OA to completely encircle the opening area OA.

Each of the first partitioning wall PW1 and the second partitioning wall PW2 may include a plurality of sequentially stacked organic insulating layers. For example, the first partitioning wall PW1 may have a structure in which a part 209P of the first organic insulating layer 209, a part 211P of the second organic insulating layer 211, a part 215P of the pixel-defining layer 215, and a part 217P of the spacer 217 are sequentially stacked. The part 209P of the first organic insulating layer 209 may be coupled to the first organic insulating layer 209 or may be separated from the first organic insulating layer 209. The second partitioning wall PW2 may have a structure in which a part of the first organic insulating layer 209, a part of the second organic insulating layer 211, and a part of the pixel-defining layer 215 are sequentially stacked.

Part of each of the functional layers or the common electrode 223 may also be on the first partitioning wall PW1 and the second partitioning wall PW2, as shown in FIG. 18.

The thin film encapsulation layer 300 that may prevent or reduce damage to or deterioration of an organic light-emitting diode OLED by external impurities may include at least one organic encapsulation layer and at least one inorganic encapsulation layer as described herein.

The first inorganic encapsulation layer 310 provided (e.g., formed) by chemical vapor deposition and/or the like has relatively superior step coverage than the functional layer and/or common electrode 223. Accordingly, as shown in FIG. 18, the first inorganic encapsulation layer 310 is not uncoupled by the first groove G1 and the second groove G2 and may cover inner side surfaces of the first groove G1 and the second groove G2.

The organic encapsulation layer 320 may be provided (e.g., formed) by applying a monomer over a substrate 100 and curing it. In embodiments, the organic encapsulation layer 320 may be provided (e.g., formed) by applying a polymer. The first partitioning wall PW1 and the second partitioning wall PW2 may serve to block or reduce the flow of a monomer or polymer in the direction to the opening area OA when the monomer or polymer is applied over the substrate 100. FIG. 18 shows that the formation area of the organic encapsulation layer 320 is limited by the first partitioning wall PW1. If the first partitioning wall PW1 and the second partitioning wall PW2 do not exist and the material for providing the organic encapsulation layer 320 is applied to the entire surface of the substrate 100, and then the through hole 10H is provided (e.g., formed) in the display panel 10, the organic encapsulation layer 320 is exposed on the inner side surface of the through hole 10H. In embodiments, the organic encapsulation layer 320 may become a path for moisture, and/or the like from the outside to penetrate through the inner side surface of the through hole 10H, which may cause a defect (for example, the organic light-emitting diode OLED of the display area DA may be damaged). However, in the display panel 10 according to one or more embodiments and the electronic apparatus 1 including the same, because the first partitioning wall PW1 and the second partitioning wall PW2 exist, the occurrence of such defects may be effectively prevented, minimized, or reduced. For reference, even if the material for providing the organic encapsulation layer 320 is excessively applied during the process of providing the organic encapsulation layer 320 and the material flows to the outside of the first partitioning wall PW1, the second partitioning wall PW2 may prevent or reduce flow of the material further toward the opening area OA.

The second inorganic encapsulation layer 330 may be over the organic encapsulation layer 320, and the second inorganic encapsulation layer 330 may be in direct contact with the first inorganic encapsulation layer 310 in some area of the intermediate area MA. For example, as shown in FIG. 18, the first inorganic encapsulation layer 310 and the second inorganic encapsulation layer 330 may be in contact with each other in some areas in the intermediate area MA, adjacent to the opening area OA.

The first groove G1 and the second groove G2 may be located between the second partitioning wall PW2 and the opening area OA. As shown in FIG. 18, grooves G having the same or similar shape as the second groove G2 may be located between the first partitioning wall PW1 and the second partitioning wall PW2, and grooves G having the same or similar shape as the second groove G2 may be located between the first partitioning wall PW1 and the second area, e.g., the display area DA. Even in the grooves G, metal layers 210 having a shape similar to the first-2 metal layer M1-2 and the second-1 metal layer M2-1 which are integrally provided (e.g., formed) as a single body and over the first organic insulating layer 209 may exist so that tips protruding into the grooves G may be provided (e.g., formed).

FIG. 18 shows that two grooves G are located between the display area DA and the first partitioning wall PW1, two grooves G are located between the first partitioning wall PW1 and the second partitioning wall PW2, and two grooves G1 and G2 are located between the second partitioning wall PW2 and the opening area OA, so that a total of twelve tips exist. In embodiments, the number of the tips may vary if necessary or desired.

The cross-sectional view of the display panel 10 shown in FIG. 18 may be regarded as a structure surrounding the opening area OA. For example, as described herein, each of the grooves G1, G2, and G of FIG. 18 may have a ring shape surrounding the opening area OA when viewed in the direction perpendicular to the upper surface of the substrate 100, as shown in FIG. 17. Similarly, each of the first partitioning wall PW1 and the second partitioning wall PW2 may also have a ring shape surrounding the opening area OA when viewed in the direction perpendicular to the upper surface of the substrate 100. Similarly, the first-1 metal layer M1-1 or the first-2 metal layer M1-2 may also have a ring shape surrounding the opening area OA when viewed in the direction perpendicular to the upper surface of the substrate 100.

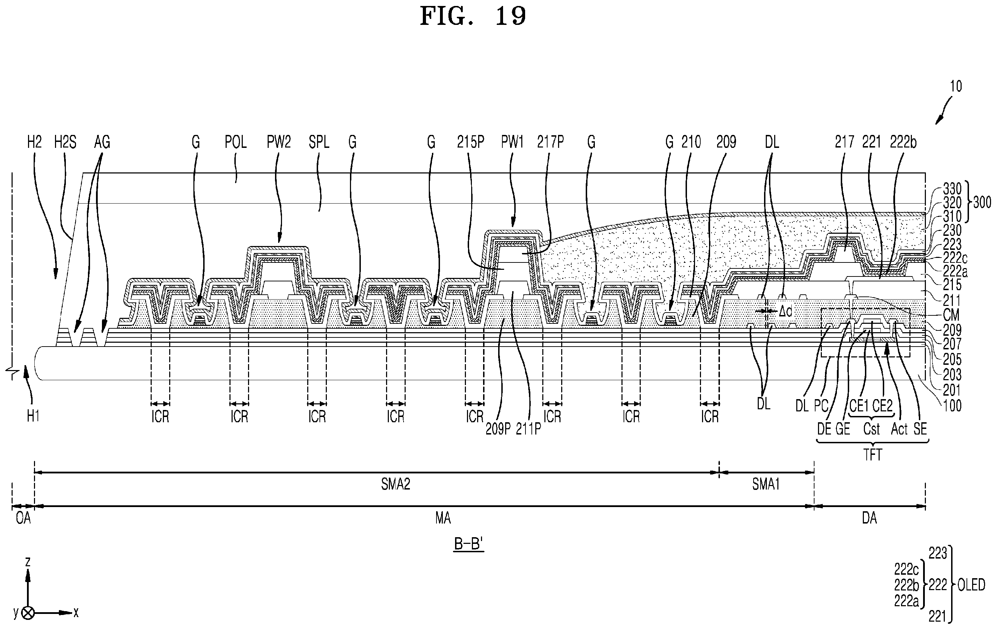

FIG. 19 is a cross-sectional view schematically illustrating a portion of a display panel 10 according to one or more embodiments. In the display panel 10 according to one or more embodiments, the buffer layer 201, the gate insulating layer 203, the first interlayer insulating layer 205, and the second interlayer insulating layer 207 included in the display layer DIL over the substrate 100 have additional grooves AG. The buffer layer 201, the gate insulating layer 203, the first interlayer insulating layer 205, and the second interlayer insulating layer 207 may be referred to as an inorganic layer, collectively. Because the inorganic layer over the substrate 100 and included in the display layer DIL has additional grooves AG, even if moisture penetrates through the inner side surface of the through hole 10H, movement of the moisture toward the display area DA may be effectively prevented, minimized, or reduced.

For reference, FIG. 18 shows that the first groove G1 and the second groove G2 are located between the second partitioning wall PW2 and the opening area OA, and the number of protruding tips protruding toward the center of the first groove G1 is two, and the number of protruding tips protruding toward the center of the second groove G2 is two. For example, FIG. 18 shows that four protruding tips are located between the second partitioning wall PW2 and the opening area OA. FIG. 19 shows that there are two protruding tips protruding toward the center of one groove G located between the second partitioning wall PW2 and the opening area OA, and that there is one protruding tip protruding in the direction from the groove G toward the opening area OA. For example, FIG. 19 shows that three protruding tips are located between the second partitioning wall PW2 and the opening area OA.

In the display panel 10 shown in FIG. 19, the inorganic layer over the substrate 100 and included in the display layer DIL has additional grooves AG as described herein, and thus even if moisture penetrates through the inner side surface of the through hole 10H, movement of the moisture toward the display area DA may be effectively prevented, minimized, or reduced. Therefore, in the display panel 10 shown in FIG. 19, the number of the protruding tips may be reduced.

For reference, both FIGS. 18 and 19 show that there are two grooves G between the first partitioning wall PW1 and the second partitioning wall PW2, and that there are two protruding tips protruding toward the center of each of the grooves G. For example, both FIGS. 18 and 19 show that four protruding tips exist between the first partitioning wall PW1 and the second partitioning wall PW2. However, one or more embodiments are not limited thereto. As shown in FIG. 19, when the inorganic layer over the substrate 100 and included in the display layer DIL has the additional grooves AG, there may be a smaller number of protruding tips than four between the first partitioning wall PW1 and the second partitioning wall PW2. For example, when the inorganic layer over the substrate 100 and included in the display layer DIL has the additional grooves AG, three protruding tips may exist between the first partitioning wall PW1 and the second partitioning wall PW2.

Although one or more embodiments have been described with reference to the embodiments shown in the drawings, these are merely examples, and those skilled in the art will understand that various suitable modifications and equivalent other embodiments are possible therefrom. Therefore, the true technical protection scope should be determined by the technical idea of the appended claims.

According to one or more embodiments as described herein, a method of manufacturing a display panel having a low defect occurrence rate, a display panel manufactured by the method, and an electronic apparatus including the display panel may be implemented. However, the scope of the disclosure is not limited to the preceding.

Terms such as "substantially," "about," and "approximately" are used as relative terms and not as terms of degree, and are intended to account for the inherent deviations in measured or calculated values that would be recognized by those of ordinary skill in the art. They may be inclusive of the stated value and an acceptable range of deviation as determined by one of ordinary skill in the art, considering the limitations and error associated with measurement of that quantity. For example, "about" may refer to one or more standard deviations, or ± 30%, 20%, 10%, 5% of the stated value.

Numerical ranges disclosed herein include and are intended to disclose all subsumed sub-ranges of the same numerical precision. For example, a range of "1.0 to 10.0" includes all subranges having a minimum value equal to or greater than 1.0 and a maximum value equal to or less than 10.0, such as, for example, 2.4 to 7.6. Applicant therefore reserves the right to amend this specification, including the claims, to expressly recite any sub-range subsumed within the ranges expressly recited herein.

The display panel, electronic apparatus, a device of manufacturing thereof, and/or any other relevant devices or components according to embodiments of the present disclosure described herein may be implemented utilizing any suitable hardware, firmware (e.g., an application-specific integrated circuit), software, or a combination of software, firmware, and hardware. For example, the one or more suitable components of the display panel and/or electronic apparatus may be provided on one integrated circuit (IC) chip or on separate IC chips. Further, the one or more suitable components of the display panel and/or electronic apparatus may be implemented on a flexible printed circuit film, a tape carrier package (TCP), a printed circuit board (PCB), or provided on one substrate. Further, the one or more suitable components of the display panel and/or electronic apparatus may be a process or thread, running on one or more processors, in one or more computing devices, executing computer program instructions and interacting with other system components for performing the one or more suitable functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, and/or the like. Also, a person of skill in the art should recognize that the functionality of one or more suitable computing devices may be combined or integrated into a single computing device, or the functionality of a particular computing device may be distributed across one or more other computing devices without departing from the scope of the embodiments of the present disclosure.

In the context of the present application and unless otherwise defined, the terms "use," "using," and "used" may be considered synonymous with the terms "utilize," "utilizing," and "utilized," respectively.

A person of ordinary skill in the art, in view of the present disclosure in its entirety, would appreciate that each suitable feature of the one or more suitable embodiments of the present disclosure may be combined or combined with each other, partially or entirely, and may be technically interlocked and operated in one or more suitable ways, and each embodiment may be implemented independently of each other or in conjunction with each other in any suitable manner unless otherwise stated or implied.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that one or more suitable changes in form and details may be made therein without departing from the scope as defined by the following claims.

## Claims

1. A method comprising:
providing a display layer (DIL) on a first surface of a substrate (100), the substrate (100) comprising the first surface and a second surface, the first surface opposite to the second surface;
etching the second surface to:
reduce a thickness of the substrate (100); and
remove a portion of the substrate (100) corresponding to a hole-forming area to form a first hole (H1) in the substrate (100);
providing a polarization layer (POL) corresponding to an entire surface of the display layer (DIL), the display layer (DIL) being between the polarization layer (POL) and the substrate (100); and
providing a second hole (H2), the second hole (H2) coupled to the first hole (H1), by removing a portion of the polarization layer (POL) and a portion of the display layer (DIL), each of the portion of the polarization layer (POL) and the portion of the display layer (DIL) corresponding to an edge of the hole-forming area,
wherein the method is a method of manufacturing a display panel (10).

2. The method of claim 1, further comprising providing a scratch in the substrate (100), the scratch corresponding to the edge of the hole-forming area,
wherein the etching of the second surface comprises:
applying an etchant to penetrate the scratch; and
removing the portion of the substrate (100) corresponding to the hole-forming area.

3. The method of claims 1 or 2, wherein the providing of the second hole (H2) comprises irradiating a laser beam to the portion of the polarization layer (POL) corresponding to the edge of the hole-forming area.

4. The method of claim 3, wherein the providing of the second hole (H2) comprises irradiating the laser beam to the portion of the polarization layer (POL) until a portion of the first surface of the substrate (100) corresponding to the edge of the hole-forming area is exposed.

5. The method of any one of the preceding claims, further comprising providing a bottom protective layer (BPL), the bottom protective layer (BPL) covering a lower surface of the display layer (DIL), wherein the lower surface is exposed by the first hole (H1), the second surface, and an inner side surface of the first hole (H1).

6. The method of claim 5, wherein the providing of the second hole (H2) comprises irradiating the laser beam to remove a portion of the bottom protective layer (BPL) on the inner side surface of the first hole (H1).

7. The method of claim 6, wherein the providing of the second hole (H2) comprises irradiating the laser beam to remove a portion of the bottom protective layer (BPL) on the second surface and to expose a portion of the second surface that is around the first hole (H1).

8. A display panel (10) comprising:
a substrate (100) comprising:
a first surface;
a second surface opposite to the first surface; and
a first hole (H1) passing through the first surface and the second surface;
a display layer (DIL); and
a polarization layer (POL) on the display layer (DIL),
wherein the display layer (DIL) is on the first surface and comprises a second hole (H2) overlapping the first hole (H1) when viewed in a direction perpendicular to the substrate (100), and
wherein an inner side surface of the second hole (H2) is a continuous surface excluding a step up to the first surface, and a portion of the first surface between the display layer (DIL) and the first hole (H1) excludes an organic film.

9. The display panel (10) of claim 8, wherein an area of the second hole (H2) at a lower surface of the polarization layer (POL) in a direction toward the display layer (DIL) is equal to an area of the second hole (H2) at an upper surface of the display layer (DIL) in a direction toward the polarization layer (POL).

10. The display panel (10) of claims 8 or 9, wherein the second hole (H2) is configured so as to expose a portion of the first surface of the substrate (100) and/or wherein the portion of the first surface of the substrate (100) is around the first hole (H1).

11. The display panel (10) of any one of the claims 8 to 10, further comprising a bottom protective layer (BPL) on the second surface of the substrate (100) and comprising a third hole (H3) corresponding to the first hole.

12. The display panel (10) of claim 11, wherein an area of the third hole (H3) is greater than an area of the first hole (H1) and/or wherein the area of the third hole (H3) at an upper surface of the bottom protective layer (BPL) in a direction toward the substrate (100) is equal to an area of the second hole (H2) at a lower surface of the display layer (DIL) in the direction toward the substrate (100)..

13. The display panel (10) of claim 12, wherein, when viewed in the direction perpendicular to the substrate (100), an edge of the third hole (H3) overlaps an edge of the second hole (H2) at the lower surface of the display layer (DIL) in a direction toward the substrate (100).

14. The display panel (10) of claims 12 or 13, wherein an edge of the third hole (H3) of the bottom protective layer (BPL) comprises a thermally deformed portion and/or the display panel (10) of any one of the claims 8 to 13, wherein an edge of the second hole (H2) of the polarization layer (POL) comprises a thermally deformed portion.

15. An electronic apparatus (1) comprising:
a display panel (10) according to any one of the claims 8 to 14;
a camera (531); and
a lower cover (90),
wherein the camera (531) is disposed between the display panel (10) and the lower cover (90).
